# EUROPEAN PATENT SPECIFICATION

(11) **EP 4 430 097 B1**
(45) Date of publication and mention of the grant of the patent: **01.04.2026**
(21) Application number: 22817567.5
(22) Date of filing: 10.11.2022
(51) Int. Cl.: G03F 7/00, C08F 8/12, C08F 220/30, C09D 133/10, H01L 21/027

(54) **NEUTRAL BRUSHES WITH TUNABLE POLARITY FOR SELF-ASSEMBLY OF BLOCK COPOLYMERS WITH POLY(STYRENE) AND POLY(METHYL METHACRYLATE) CONTAINING SEGMENTS**
NEUTRALE BÜRSTEN MIT EINSTELLBARER POLARITÄT FÜR DIE SELBSTMONTAGE VON BLOCKCOPOLYMEREN MIT POLY(STYROL) UND POLY(METHYLMETHACRYLAT) ENTHALTENDEN SEGMENTEN
BROSSES NEUTRES À POLARITÉ RÉGLABLE POUR L'AUTO-ASSEMBLAGE DE COPOLYMÈRES À BLOCS CONTENANT DES SEGMENTS DE POLY(STYRÈNE) ET DE POLY(MÉTHACRYLATE DE MÉTHYLE)

(30) Priority: 12.11.2021 US 202163263973 P
(43) Date of publication of application: 18.09.2024
(73) Proprietor: Merck Patent GmbH, 64293 Darmstadt (DE)
(72) Inventor: BASKARAN, Durairaj, Branchburg, New Jersey 08876 (US); KANG, Namgoo, Branchburg, New Jersey 08876 (US); NG, Edward W., Branchburg, New Jersey 08876 (US)
(74) Representative: Rippel, Hans Christoph
(86) International application number: PCT/EP2022/081410
(87) International publication number: WO 2023/083933

(56) References cited:
- WO-A1-2021/105086
- JP-A- 2019 218 519
- US-A1- 2017 170 008
- US-A1- 2018 096 838
- ZHAO JIACHENG ET AL: "Photo-directing chemoepitaxy: the versatility of poly(aryl methacrylate) films in tuning block copolymer wetting", POLYMER CHEMISTRY, vol. 12, no. 21, 8 May 2021 (2021-05-08), Cambridge, pages 3201 - 3209, XP093029898, ISSN: 1759-9954, Retrieved from the Internet <URL:https://pubs.rsc.org/en/content/articlepdf/2021/py/d1py00501d> [retrieved on 20230309], DOI: 10.1039/D1PY00501D
- CHAE CHANG-GEUN ET AL: "End-Capping Reaction of Living Anionic Poly(benzyl methacrylate) with a Pentafluorophenyl Ester for a Norbornenyl-[omega]-End Macromonomer with a Long Flexible Spacer: Advantage in the Well-Controlled Synthesis of Ultrahigh-Molecular-Weight Bottlebrush Polymers", MACROMOLECULES, vol. 52, no. 13, 20 June 2019 (2019-06-20), US, pages 4828 - 4838, XP093030191, ISSN: 0024-9297, Retrieved from the Internet <URL:https://pubs.acs.org/doi/pdf/10.1021/acs.macromol.9b00559> [retrieved on 20230309], DOI: 10.1021/acs.macromol.9b00559

## Description

The invention relates to neutral brush composition for use in directed self-assembly processing.

### BACKGROUND

Self-assembly of block copolymers is a method useful for generating smaller and smaller patterned features for the manufacture of microelectronic devices in which the critical dimensions (CD) of features on the order of nanoscale can be achieved. Self-assembly methods are desirable for extending the resolution capabilities of microlithographic technology for repeating features such as an array of contact holes or posts. In a conventional lithography approach, ultraviolet (UV) radiation may be used to expose through a mask onto a photoresist layer coated on a substrate or layered substrate. Positive or negative photoresists are useful, and these can also contain a refractory element such as silicon to enable dry development with conventional integrated circuit (IC) plasma processing. In a positive photoresist, UV radiation transmitted through a mask causes a photochemical reaction in the photoresist such that the exposed regions are removed with a developer solution or by conventional IC plasma processing. Conversely, in negative photoresists, UV radiation transmitted through a mask causes the regions exposed to radiation to become less removable with a developer solution or by conventional IC plasma processing. An integrated circuit feature, such as a gate, via or interconnect, is then etched into the substrate or layered substrate, and the remaining photoresist is removed. When using conventional lithographic exposure processes, the dimensions of features of the integrated circuit feature are limited. Further reduction in pattern dimensions is difficult to achieve with radiation exposure due to limitations related to aberrations, focus, proximity effects, minimum achievable exposure wavelengths and maximum achievable numerical apertures. The need for large-scale integration has led to a continued shrinking of the circuit dimensions and features in the devices. In the past, the final resolution of the features has been dependent upon the wavelength of light used to expose the photoresist, which has its own limitations. Directed (a.k.a. guided) self-assembly techniques, such as graphoepitaxy and chemoepitaxy using block copolymer imaging, which employ a patterned area on a substrate, are highly desirable techniques used to enhance resolution while reducing CD variation. These techniques can be employed to either enhance conventional UV lithographic techniques or to enable even higher resolution and CD control in approaches employing EUV, e-beam, deep UV or immersion lithography. The directed self-assembly block copolymer comprises a block of etch resistant copolymeric unit and a block of highly etchable copolymeric unit, which when coated, aligned and etched on a substrate give regions of very high-density patterns.

For directed (guided), or unguided self-assembly, of a block copolymer film, respectively, on a patterned or non-patterned substrate area, typically the self-assembly process of this block polymer layer occurs during annealing of this film overlying a neutral layer. This neutral layer over a semiconductor substrate may be an unpatterned neutral layer, or in chemoepitaxy or graphoepitaxy, this neutral layer may contain, respectively, graphoepitaxy or chemoepitaxy guiding features (formed through the above-described UV lithographic technique). During annealing of the block copolymer film, the underlying, neutral layer, directs the nano-phase separation of the block copolymer domains. One example is the formation phase separated domains which are lamellas or cylinders perpendicular to the underlying neutral layer surface. These nanophase separated block copolymer domains form a pre-pattern (e.g., line and space L/S) which may be transferred into the substrate through an etching process (e.g., plasma etching). In graphoepitaxy, or in chemoepitaxy, these guiding features may dictate both pattern rectification and pattern multiplication. In the case of an unpatterned neutral layer this produces a repeating array of for instance L/S or CH. For example, in a conventional block copolymer such as poly(styrene-b-methyl methacrylate (P(S-b-MMA)), in which both blocks have similar surface energies at the BCP-air interface, this can be achieved by coating and thermally annealing the block copolymer on a layer of non-preferential or neutral material that is grafted or cross-linked at the polymer-substrate interface.

In the graphoepitaxy directed self-assembly method, the block copolymers self organizes around a substrate that is pre-patterned with conventional lithography (Ultraviolet, Deep UV, e-beam (electron-beam), Extreme UV (EUV) exposure source) to form repeating topographical features such as a line/space (L/S) or contact hole (CH) pattern. In an example of a L/S directed self-assembly array, the block copolymer can form self-aligned lamellar regions which can form parallel line-space patterns of different pitches in the trenches between pre-patterned lines, thus enhancing pattern resolution by subdividing the space in the trench between the topographical lines into finer patterns. For example, a diblock copolymer or a triblock copolymer which is capable of microphase separation and comprises a block rich in carbon (such as styrene or containing some other element like Si, Ge, Ti) which is resistant to plasma etch, and a block which is highly plasma etchable or removable, can provide a high-resolution pattern definition. Examples of highly etchable blocks can comprise monomers which are rich in oxygen and which do not contain refractory elements and are capable of forming blocks which are highly etchable, such as methyl methacrylate. The plasma etching gases used in the etching process of defining the self-assembly pattern typically are those used in processes employed to make integrated circuits (IC). In this manner, very fine patterns can be created in typical IC substrates than were definable by conventional lithographic techniques, thus achieving pattern multiplication. Similarly, features such as contact holes can be made denser by using graphoepitaxy in which a suitable block copolymer arranges itself by directed self-assembly around an array of contact holes or posts defined by conventional lithography, thus forming a denser array of regions of etchable and etch resistant domains which when etched give rise to a denser array of contact holes. Consequently, graphoepitaxy has the potential to offer both pattern rectification and pattern multiplication.

In chemical epitaxy, or pinning chemical epitaxy, the self-assembly of the block copolymer is formed on a surface whose guiding features are regions of differing chemical affinity, having no, or insignificant topography (a.k.a. non-guiding topography) which predicates the directed self-assembly process. For example, the surface of a substrate could be patterned with conventional lithography (UV, Deep UV, e-beam, EUV) to create surfaces of different chemical affinity in a line and space (L/S) pattern in which exposed areas whose surface chemistry had been modified by irradiation alternate with areas which are unexposed and show no chemical change. These areas present no topographical difference but do present a surface chemical difference or pinning to direct self-assembly of block copolymer segments. Specifically, the directed self-assembly of a block copolymer whose block segments contain etch resistant (such as styrene repeat unit) and rapidly etching repeat units (such as methyl methacrylate repeat units) would allow precise placement of etch resistant block segments and highly etchable block segments over the pattern. This technique allows for the precise placement of these block copolymers and the subsequent pattern transfer of the pattern into a substrate after plasma or wet etch processing. Chemical epitaxy has the advantage that it can be fine-tuned by changes in the chemical differences to help improve line-edge roughness and CD control, thus allowing for pattern rectification. Other types of patterns such as repeating contact holes (CH) arrays could also be pattern rectified using chemoepitaxy.

These neutral layers are layers on a substrate or the surface of a treated substrate which have no affinity for either of the block segment of a block copolymer employed in directed self-assembly. In the graphoepitaxy method of directed self-assembly of block copolymer, neutral layers are useful as they allow the proper placement or orientation of block polymer segments for directed self-assembly which leads to proper placement of etch resistant block polymer segments and highly etchable block polymer segments relative to the substrate. For instance, in surfaces containing line and space features which have been defined by conventional radiation lithography, a neutral layer allows block segments to be oriented so that the block segments are oriented perpendicular to the surface of the substrates, an orientation which is ideal for both pattern rectification and pattern multiplication depending on the length of the block segments in the block copolymer as related to the length between the lines defined by conventional lithography. If a substrate interacts too strongly with one of the block segments it would cause it to lie flat on that surface to maximize the surface of contact between the segment and the substrate; such a surface would perturb the desirable perpendicular alignment which can be used to either achieve pattern rectification or pattern multiplication based on features created through conventional lithography. Modification of selected small areas or pinning of substrate to make them strongly interactive with one block of the block copolymer and leaving the remainder of the surface coated with the neutral layer can be useful for forcing the alignment of the domains of the block copolymer in a desired direction, and this is the basis for the pinned chemoepitaxy or graphoepitaxy employed for pattern multiplication. The pinning area may be one which is hydrophilic having a greater affinity for example to polar block copolymer segments such as the polymethyl methacrylate block segment in a block copolymer of styrene and methyl methacrylate or alternatively be a pinning area which may be hydrophobic having a greater affinity for example to the polystyrene block segments in a block copolymer of styrene and methyl methacrylate.

For DSA LiNe flow (Liu-Nealey flow) processes employing block copolymers such as a 50/50 block copolymer of styrene and methyl methacrylate (PS-b-PMMA), typically 50/50 random copolymer of styrene and methyl methacrylate (PS-r-PMMA) with a reactive chain-end functionality, which are prepared by radical polymerization, are employed. Because these type of copolymers are prepared with radical polymerization methods, this results in copolymer with high polydispersity (PDI- 1.6-1.8) and thus form grafted neutral layer with poor uniformity. Neutral brushes based on PS-b-PMMA prepared by anionic polymerization are also known, however these materials have a hydrophobicity which is not easily tunable. Further, although polymers and copolymers based on alkyl or aryl methacrylate, such as benzyl methacrylate without graftable end groups prepared by radical polymerization and having high polydispersity are known, there is a need for such polymers in DSA application which have a reactive end group and narrow polydispersity. Such materials are needed not only because they could potentially form uniform neutral layers, but also because they could easily have their hydrophobicity finely tuned by varying the ratio of alkyl to aryl methacrylate repeat units. Such tunable material would not only solve the problem of lack of neutral layer uniformity in DSA LiNe flow processes, but also prevent the problem of missing DSA guide pattern disruptions, much more efficiently than conventional neutral brushes such as PS-r-MMA-OH or PS-b-MMA-OH. Specific examples of random (co)polymers used for directed self-assembly of block copolymers can be found in WO 2021/105086 A1, US 2018/096838 A1 and *Photo-directing chemoepitaxy: the versatility of poly(aryl methacrylate) films in tuning block copolymer wetting* by Jiacheng Zhao et al.

### DETAILED DESCRIPTION OF DRAWINGS

**FIG. 1** Shows a representative polymer, which would be obtained with a hydroxyl protected diphenylethylene as initiator adduct with sec-BuLi.
**FIG. 2** Shows a polymer which would be obtained by initiation with a sec-BuLi 1,1-diphenylethene adduct, but which is capped with a protected 2-hydroxyethyl 2-phenylacrylate and terminated.
**FIG. 3** Shows 1FOV SEM images of each fingerprint pattern on a silicon wafer using A) PS-b-PMMA on P(BnMA-r-BPMA_{25%})-OH (Mn: 13K, brush FT: 4.2 nm ± 0.3, WCA: 81.0 ± 2.3) B) PS-b-PMMA on P(BnMA-r-CHMA_{25%})-OH(Mn: 23K, brush FT: 3.8 nm ± 0.3, WCA: 79.4 ± 0.5) C) PS-b-PMMA on P(BnMA-r-AMMA_{20%}-OH) (Mn: ~ 7.0K, brush FT: 7.9 nm ± 0.3, WCA: 80.8 ± 0.5). Process conditions: Si wafer, coat NLD, 200°C/ 30 min/ N2 (Polymer A, B, & C, 230°C), 15 min toluene soak, N2 blow dry, PME-7167 Ctg65: L₀ = 48 nm, FT = 50 nm, 270° C/1 h (N₂)

### SUMMARY OF THE INVENTION

One aspect of this invention is novel graftable polymers which, depending on the composition of alkyl or aryl substituted methacrylate monomer with repeat units such as benzyl methacrylate and its derivatives, can have their neutrality tuned either towards hydrophilic or hydrophobic enhancement in how it interacts with the polar or non-polymer block copolymer segments in block copolymers such as PS-b-PMMA block copolymer. One approach to these polymers is to use novel hydroxyl protected diphenylethylene as initiator adduct with sec-BuLi to initiate (alkyl or aryl) methacrylates to form well-defined pre-determined molecular weight brushes with low polydispersity for perpendicular assembly of block copolymers such as PS-b-PMMA type di- or multi-block copolymers. Another approach in this invention is to employ a standard alkyl lithium initiator but to terminate the living polymer chain with a protected hydroxyalkyl 2-arylacryalte, such as a protected 2-hydroxyethyl 2-phenylacrylate, forming also well-defined pre-determined molecular weight brushes with low polydispersity.

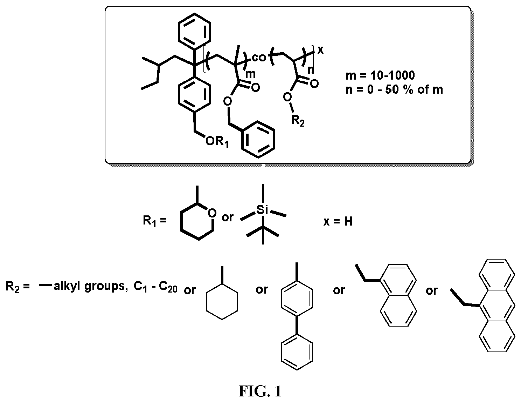

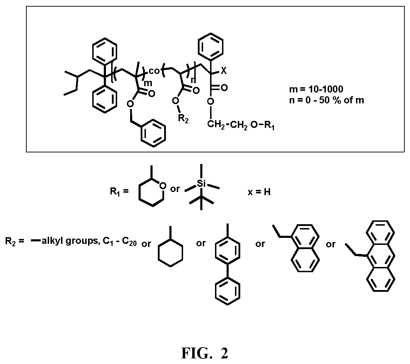

Using either of these anionic copolymerization, different compositions of these methacrylates can be made to tune hydrophilicity or hydrophobicity to induce subtle changes in neutrality for suitable application requirements in DSA. FIG. 1 and FIG. 2 show representative specific examples of such materials. where FIG. 1 shows a representative polymer, which would be obtained with a hydroxyl protected diphenylethylene as initiator adduct with sec-BuLi. FIG. 2. Shows a copolymer which would be obtained by initiation with a sec-BuLi 1,1-diphenylethene adduct, but which is capped with a protected 2-hydroxyethyl 2-phenylacrylate and terminated.

In one of its aspect this invention describes a random polymer of structure (A), comprising:
- a repeat unit of structure (I), where Rₘ₁ is a C-1 to C-8 alkyl, R₁ is a benzylic comprising moiety of structure (V) wherein R_{benz} is a substituent individually selected from H, a C-1 to C-4 alkyl, and a C-1 to C-4 alkoxy, L₃ is a C-1 to C-4 alkylene, and "*" designates the attachment point of the this substituent to this repeat unit, and n₁ designates the number of this repeating unit in the polymer, and further where the mole % of this repeat unit is from about 40 mole % to about 100 mole %,
- a repeat unit of structure (II), wherein , Rₘ₂ is a C-1 to C-8 alkyl, R₂ is a moiety selected from a C-1 to C-20 linear alkyl, a C-3 to C-20 branched alkyl, and a C-5 to C-20 cyclic alkyl, a cyclohexylalkylene moiety of structure (VI), an anthracenylalkylene moiety of structure (VII), a naphthalenylalkylene moiety of structure (VIII), and a biphenyl moiety of structure (VIV), wherein L₄ and L₅ are each independently selected from a C-1 to C-4 alkylene, L₆ and L₇ are each independently selected from a direct valence bond or a C-1 to C-4 alkylene moiety, R_{cycl}, Rₐₙₜₕ, Rₙₐₚₕ, R_{biph}, are substituents each individually selected from H, a C-1 to C-4 alkyl, and a C-1 to C-4 alkoxy, n₂ designates the number of this repeating unit in the polymer, and further where the mole % of this repeat unit is from about 0 mole % to about 60 mole %,: and further wherein the total mole % of the repeat units in said polymer of repeat units of structures (I) and (II) is 100 mole %
- two end groups R₃ and R₄, wherein
   ∘ end group R₃, which is derived from an anionic initiator, and is either a moiety of structure (IIIa) or is a moiety of structure (III), wherein L₁ is a C-1 to C-8 alkylene, and R₅ is H, an acetal protecting group, or a trialkylsilyl protecting group, R₆ is a C-1 to C-8 alkyl, and Rₑ₁ and Rₑ₂ are individually selected from H, a C-1 to C-8 alkyl, and a C-1 to C-8 alkoxy, and "*" designates the attachment point of this end group to said polymer of structure (A), and
   ∘ end group R₄, which is a moiety derived from termination of anionic polymerization, wherein R₄ is either selected from the group consisting of H, a C-1 to C-8 alkyl, C-1 to C-8 alkylcarbonyl (alkyl-C(=O)-), a C-1 to C-8 trialkylsilyl ((alkyl)₃Si), a C-1 to C-8 dialkylsilyl ((alkyl)₂HSi), a C-1 to C-8 monoalkylsilyl- ((alkyl)H₂Si-), silane (-H₃Si-), and a benzylic moiety, or is a moiety of structure (IV), wherein L₂ is a C-2 to C-8 alkylene, and R₇ is H, an acetal protecting group, or a trialkylsilyl protecting group, R₈ is selected from the group consisting of H, a C-1 to C-8 alkyl, C-1 to C-8 alkylcarbonyl (alkyl-C(=O)-), a C-1 to C-8 trialkylsilyl ((alkyl)₃Si), a C-1 to C-8 dialkylsilyl ((alkyl)₂HSi), a C-1 to C-8 monoalkylsilyl- ((alkyl)H₂Si-), silane (-H₃Si-), and a benzylic moiety and Rₑ₃ is selected from H, a C-1 to C-8 alkyl, and a C-1 to C-8 alkoxy, and "*" designates the attachment point of the end group to said polymer of structure (A), and further, wherein
   ∘ both R₃ and R₄ cannot, simultaneously, be respectively selected from a moiety of structure (III), and a moiety of structure (IV), and
   ∘ either R₃ is a moiety of structure (III) or R₄ is a moiety of structure (IV):

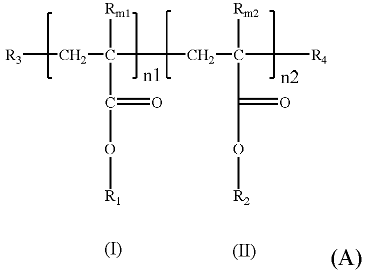

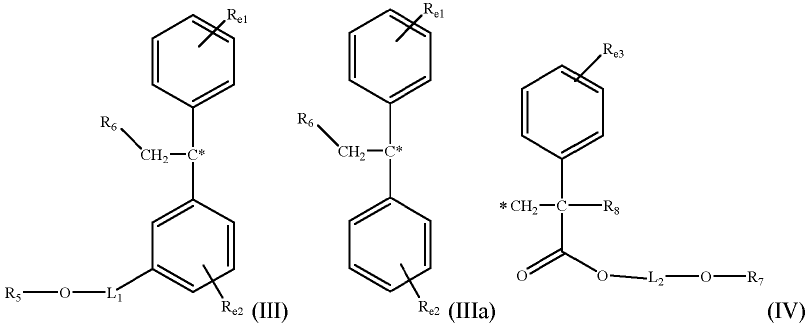

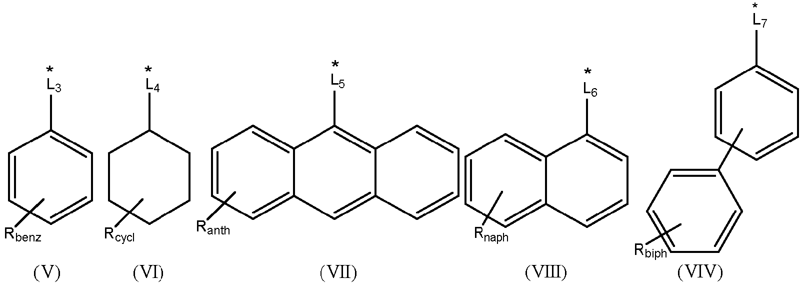

Another aspect of this invention is a composition comprising an inventive polymer of structure (A) and an organic spin casting solvent, wherein said polymer is one wherein either end group (III) is present and R₅ is H or end group (IV) is present, and R₇ is H.

A further aspect of this invention a processes of grafting said inventive composition comprising the polymer of structure (A) on a substrate and using this grafted layer as a neutral layer in directed self-assembly (DSA) processing.

### DETAILED DESCRIPTION OF THE INVENTION

In this application, the use of the singular includes the plural, the word "a" or "an" means "at least one", and the use of "or" means "and/or", unless specifically stated otherwise. Furthermore, the use of the term "including," "comprising" as well as other forms such as "includes", "comprises", "comprised" and "included", is not limiting. Also, terms such as "element" or "component" encompass both elements and components comprising one unit and elements or components that comprise more than one unit, unless specifically stated otherwise. As used herein, the conjunction "and" is intended to be inclusive and the conjunction "or" is not intended to be exclusive unless otherwise indicated. For example, the phrase "or, alternatively" is intended to be exclusive. As used herein, the term "and/or" refers to any combination of the foregoing elements including using a single element.

The term "C-1 to C-4 alkyl" embodies methyl and C-2 to C-4 linear alkyls and C-3 to C-4 branched alkyl moieties, for example as follows: methyl(-CH₃), ethyl (-CH₂-CH₃), n-propyl (-CH₂-CH₂-CH₃), isopropyl (-CH(CH₃)₂, n-butyl (-CH₂-CH₂-CH₂-CH₃), tert-butyl (-C(CH₃)₃), isobutyl (CH₂-CH(CH₃)₂, 2-butyl (-CH(CH₃)CH₂-CH₃). Similarly, the term C-1 to C-8 embodies methyl C-2 to C-8 linear, C-3 to C-8 branched alkyls, C-4 to C-8 cycloalkyls (e.g., cyclopentyl, cyclohexyl etc) or C-5-C-8 alkylenecycloalkyls (e.g., -CH₂-cyclohexyl, CH₂-CH₂-cyclopentyl etc.

The term "C-2 to C-5 alkylene" embodies C-2 to C-5 linear alkylene moieties (e.g. ethylene, propylene etc.) and C-3 to C-5 branched alkylene moieties (e.g., -CH(CH₃)-, -CH(CH₃)-CH₂-, etc.).

Di-block and triblock copolymers of styrenic and alkyl 2-methylenealkanoate derived repeat unit moieties useful as components in the inventive compositions described herein may be made by a variety of methods, such as anionic polymerization, atom transfer radical polymerization (ATRP), Reversible addition-fragmentation chain transfer (RAFT) polymerization, living radical polymerization and the like (Macromolecules 2019, 52, 2987-2994; Macromol. Rapid Commun. 2018, 39, 1800479; A. Deiter Shluter et al Synthesis of Polymers, 2014, Volume 1, p315; Encyclopedia of Polymer Science and Technology, 2014, Vol 7, p 625.).

The random copolymer poly(styrene-co-methyl methacrylate) is abbreviated as "P(S-co-MMA)," and the oligomeric version of this materials is abbreviated oligo(S-co-MMA). Similarly, the block copolymer poly(styrene-block-methyl methacrylate) is abbreviated as P(S-b-MMA), while the oligomer of this material is abbreviated as oligo(S-b-MMA). The oligomer oligo(styrene-co-p-octylstyrene)-block-(methyl methacrylate-co- diethylene glycol) methyl ether methacrylate) uses the same abbreviations to designate random an block copolymer elements, specifically oligo(S-co-p-OS)-b-P(MMA-co-DEGMEMA), in which S=styrene, p-OS=para-octylstyrene, MMA=methacrylate, DEGMEMA= di(ethylene glycol) methyl ether methacrylate designate the repeat units in this block copolymer whose two blocks are random copolymers.

FOV is the abbreviation for "field of view" for top-down scanning electron micrographs (SEM) for the SEM FIGs. in this application. "L/S," is an abbreviation for "line and space" lithographic features.

PGMEA and PGME are respectively abbreviations for 1-methoxypropan-2-yl acetate and 1-methoxypropan-2-ol.

The section headings used herein are for organizational purposes and are not to be construed as limiting the subject matter described.

Unless otherwise indicated, "alkyl" refers to hydrocarbon groups which can be linear, branched (e.g. methyl, ethyl, propyl, isopropyl, tert-butyl and the like) or cyclic (e.g. cyclohexyl, cyclopropyl, cyclopentyl and the like) multicyclic (e.g. norbornyl, adamantly and the like). These alkyl moieties may be substituted or unsubstituted as described below. The term "alkyl" refers to such moieties with C-1 to C-8 carbons. It is understood that for structural reasons linear alkyls start with C-1, while branched alkyls and cyclic alkyls start with C-3 and multicyclic alkyls start with C-5. Moreover, it is further understood that moieties derived from alkyls described below, such as alkyloxy and perfluoroalkyl, have the same carbon number ranges unless otherwise indicated. If the length of the alkyl group is specified as other than described above, the above-described definition of alkyl still stands with respect to it encompassing all types of alkyl moieties as described above and that the structural consideration with regards to minimum number of carbons for a given type of alkyl group still apply.

Alkyloxy (a.k.a. Alkoxy) refers to an alkyl group on which is attached through an oxy (-O-) moiety (e.g. methoxy, ethoxy, propoxy, butoxy, 1,2-isopropoxy, cyclopentyloxy cyclohexyloxy and the like). These alkyloxy moieties may be substituted or unsubstituted as described below.

Halo or halide refers to a halogen, F, Cl, Br or I which is linked by one bond to an organic moiety.

As used herein the term lactone encompasses both mono-lactones (e.g., caprolactone) and di-lactones (e.g., lactide).

Haloalkyl refers to a linear, cyclic or branched saturated alkyl group such as defined above in which at least one of the hydrogens has been replaced by a halide selected from the group of F, Cl, Br, I or mixture of these if more than one halo moiety is present. Fluoroalkyls are a specific subgroup of these moieties.

Perfluoroalkyl refers to a linear, cyclic or branched saturated alkyl group as defined above in which the hydrogens have all been replaced by fluorine (e.g., trifluoromethyl, perfluoroethyl, perfluoroisopropyl, perfluorocyclohexyl and the like).

The term "hydroxyl protected diphenylethylene" refers to diphenylethylene derivatized with a C-1 to C-8 alkylene hydroxy moiety (-alkylene-OH), on at least one of the aromatic rings, where the hydroxy moiety is functionalized with a protecting group (-alkylene-O-protecting group) such as an acetal (e.g. THP protecting group) or a trialkylsilyl protecting group moiety (e.g. -Si(CH₃)₂-*tert*Bu) which will not be cleaved by alkyl alkali (e.g. sec-BuLi) and allow for the formation of the hydroxy protected diphenylethylene initiator adduct with alkyl alkali (e.g. sec-BuLi).

### Polymer of structure (A)

In one of its aspect this invention describes a random polymer of structure (A), comprising:
- a repeat unit of structure (I), where Rₘ₁ is a C-1 to C-8 alkyl, R₁ is a benzylic comprising moiety of structure (V) wherein R_{benz} is a substituent individually selected from H, a C-1 to C-4 alkyl, and a C-1 to C-4 alkoxy, L₃ is a C-1 to C-4 alkylene, and "*" designates the attachment point of this substituent to this repeat unit, and n₁ designate the number of this repeating unit in the polymer, and further where the mole % of this repeat unit is from about 40 mole % to about 100 mole %,
- a repeat unit of structure (II), wherein, Rₘ₂ is a C-1 to C-8 alkyl, R₂ is a moiety selected from a C-1 to C-20 linear alkyl, a C-3 to C-20 branched alkyl, and a C-5 to C-20 cyclic alkyl, a cyclohexylalkylene moiety of structure (VI), an anthracenylalkylene moiety of structure (VII), a naphthalenylalkylene moiety of structure (VIII), and a biphenyl moiety of structure (VIV), wherein L₄ and L₅ are independently selected from a C-1 to C-4 alkylene, L₆ and L₇ are independently selected from a direct valence bond or a C-1 to C-4 alkylene moiety, R_{cycl}, Rₐₙₜₕ, Rₙₐₚₕ, R_{biph}, are substituents individually selected from H, a C-1 to C-4 alkyl, and a C-1 to C-4 alkoxy, n₂ designates the number of this repeating unit in the polymer, and further where the mole % of this repeat unit is from about 0 mole % to about 60 mole %, and further wherein the total mole % of the repeat units in said polymer of repeat units of structures (I) and (II) is 100 mole %
- two end groups R₃ and R₄, wherein
   ∘ end group R₃, which is derived from an anionic initiator, and is either a moiety of structure (IIIa) or is a moiety of structure (III), wherein L₁ is a C-1 to C-8 alkylene, and R₅ is H, an acetal protecting group, or a trialkylsilyl protecting group, R₆ is a C-1 to C-8 alkyl, and Rₑ₁ and Rₑ₂ are individually selected from H, a C-1 to C-8 alkyl, and a C-1 to C-8 alkoxy, and "*" designates the attachment point of this end group to said polymer of structure (A), and
   ∘ end group R₄, which is a moiety derived from termination of anionic polymerization, wherein R₄ is either selected from the group consisting of H, a C-1 to C-8 alkyl, C-1 to C-8 alkylcarbonyl (alkyl-C(=O)-), a C-1 to C-8 trialkylsilyl ((alkyl)₃Si), a C-1 to C-8 dialkylsilyl ((alkyl)₂HSi), a C-1 to C-8 monoalkylsilyl- ((alkyl)H₂Si-), silane (-H₃Si-), and a benzylic moiety, or is a moiety of structure (IV), wherein L₂ is a C-2 to C-8 alkylene, and R₇ is H, an acetal protecting group, or a trialkylsilyl protecting group, R₈ is selected from the group consisting of H, a C-1 to C-8 alkyl, C-1 to C-8 alkylcarbonyl (alkyl-C(=O)-), a C-1 to C-8 trialkylsilyl ((alkyl)₃Si), a C-1 to C-8 dialkylsilyl ((alkyl)₂HSi), a C-1 to C-8 monoalkylsilyl- ((alkyl)H₂Si-), silane (-H₃Si-), and a benzylic moiety and Rₑ₃ is selected from H, a C-1 to C-8 alkyl, and a C-1 to C-8 alkoxy, and "*" designates the attachment point of the end group to said polymer of structure (A), and further, wherein
   ∘ both R₃ and R₄ cannot, simultaneously, be respectively selected from a moiety of structure (III), and a moiety of structure (IV), and
   ∘ either R₃ is a moiety of structure (III) or R₄ is a moiety of structure (IV):
      - 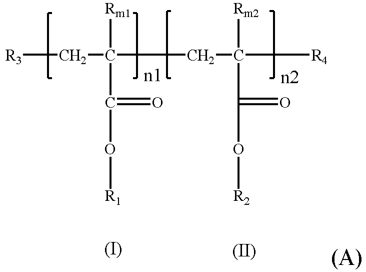
      - 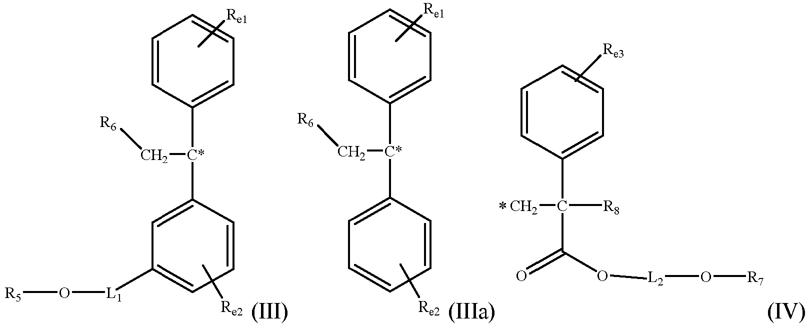
      -

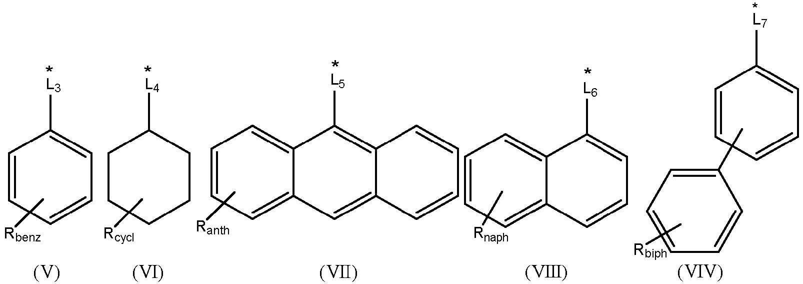

Another aspect of the inventive polymer of structure (A) is when it has structure (A-1), wherein R₄ is selected from the group consisting of H, a C-1 to C-8 alkyl, C-1 to C-8 alkylcarbonyl (alkyl-C(=O)-), a C-1 to C-8 trialkylsilyl ((alkyl)₃Si), a C-1 to C-8 dialkylsilyl ((alkyl)₂HSi), a C-1 to C-8 monoalkylsilyl- ((alkyl)H₂Si-), silane (-H₃Si-), and a benzylic moiety:

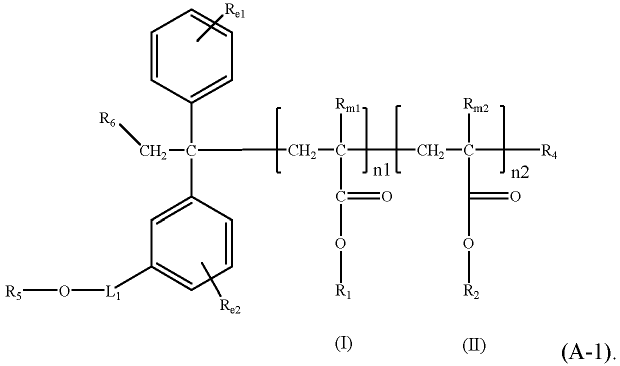

Another aspect of the inventive polymer of structure (A) is when it has structure (A-2), wherein R₈ is selected from the group consisting of H, a C-1 to C-8 alkyl, C-1 to C-8 alkylcarbonyl (alkyl-C(=O)-), a C-1 to C-8 trialkylsilyl ((alkyl)₃Si), a C-1 to C-8 dialkylsilyl ((alkyl)₂HSi), a C-1 to C-8 monoalkylsilyl-((alkyl)H₂Si-), silane (-H₃Si-), and a benzylic moiety:

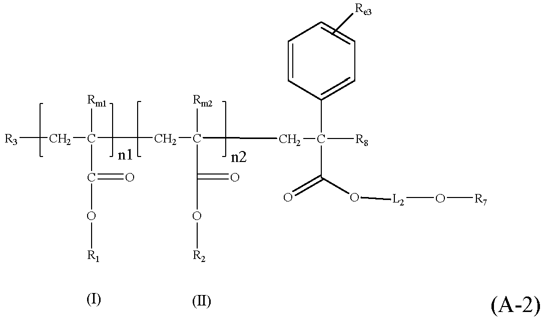

Another aspect of the inventive polymer described herein it is one wherein said repeat unit of structure (I) is 100 mole % of the repeat units and said repeat unit of structure (II) is 0 mole %.

In another aspect of the inventive polymer of structure (A), said repeat unit of structure (II) is present. In one aspect of this embodiment said repeat unit of structure (II) is one wherein R₂ is a C-1 to C-20 linear alkyl. In another aspect of this embodiment said repeat unit of structure (II) is one wherein R₂ is a C-3 to C-20 branched alkyl. In yet another aspect of this embodiment said repeat unit of structure (II) is one wherein R₂ is a C-5 to C-20 cyclic alkyl. In still another aspect of this embodiment said repeat unit of structure (II) is one wherein R₂ is a cyclohexylalkylene moiety of structure (VI). In yet another aspect of this embodiment, said repeat unit of structure (II) is one wherein R₂ is an anthracenylalkylene moiety of structure (VII). In still another aspect said repeat unit of structure (II) is one wherein R₂ is a naphthalenylalkylene moiety of structure (VIII). In yet another aspect of this embodiment, said repeat unit of structure (II) is one wherein R₂ is a biphenyl moiety of structure (VIV).

Another aspect of the inventive polymer described herein it is one wherein Rₘ₁ is a C-1 to C-4 alkyl.

Another aspect of the inventive polymer described herein it is one wherein Rₘ₁ is methyl.

Another aspect of the inventive polymer described herein it is one wherein Rₘ₂ is a C-1 to C-4 alkyl.

Another aspect of the inventive polymer described herein it is one wherein Rₘ₂ is methyl.

In another aspect of the inventive polymer of structure (A), as described herein, R₃ has structure (III) and L₁ is a C-1 to C-2 alkylene. In another aspect this embodiment, R₃ has structure (III) and L₁ is methylene. In yet another aspect of this embodiment, R₃ has structure (III) and R₅ is H. In still another aspect of this embodiment, R₃ has structure (III) and R₅ is an acetal protecting group. In still another aspect of this embodiment, R₃ has structure (III) and R₅ is a trialkylsilyl protecting group. In yet another aspect of this embodiment, R₃ has structure (III) and R₆ is a C-1 to C-6 alkyl. In still another aspect of this embodiment, R₃ has structure (III) and R₆ is isobutyl. In still another aspect of this embodiment, R₃ has structure (III) and, Rₑ₁ is H. In yet another aspect of this embodiment, R₃ has structure (III) and Rₑ₁ is a C-1 to C-8 alkyl. In still another aspect of this embodiment, R₃ has structure (III) and Rₑ₁ is a C-1 to C-8 alkoxy. In still another aspect of this embodiment, R₃ has structure (III) and Rₑ₂ is H. In still another aspect of this embodiment, R₃ has structure (III) and Rₑ₂ is a C-1 to C-8 alkyl. In yet another aspect of this embodiment, R₃ has structure (III) and Rₑ₂ a C-1 to C-8 alkoxy.

In another aspect of the inventive polymer of structure (A), as described herein, R_{benz} is H. In another aspect of this embodiment, R_{benz} is a C-1 to C-4 alkyl. In another aspect of this embodiment R_{benz} is a C-1 to C-4 alkoxy.

In another aspect of the inventive polymer of structure (A), as described herein, L₃ is a C-1 to C-3 alkylene. In another aspect of this embodiment L₃ is a C-1 to C-2 alkylene. In yet another aspect of this embodiment of this embodiment L₃ is ethylene. In still another aspect of this embodiment of this embodiment L₃ is methylene.

In another aspect of the inventive polymer of structure (A), as described herein, said polymer has structure (A-3), in another aspect of this embodiment, R₂ is a C-1 to C-20 linear alkyl. In yet another aspect of this embodiment R₂ is a C-3 to C-20 branched alkyl. In still another aspect of this embodiment, R₂ is a C-5 to C-20 cyclic alkyl.

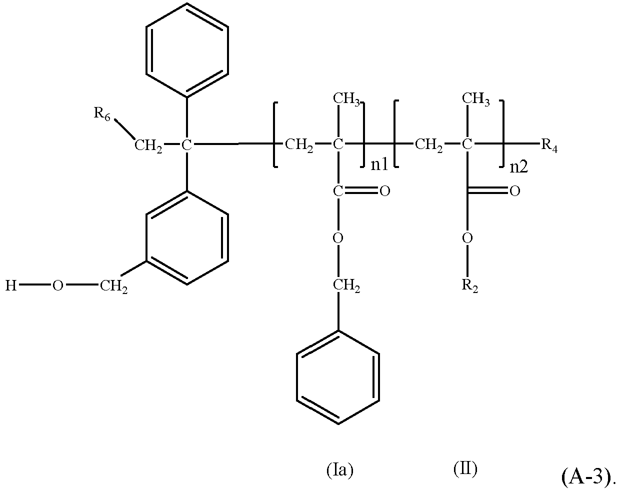

In another aspect of the inventive polymer of structure (A), as described herein, said polymer has structure (A-3a):

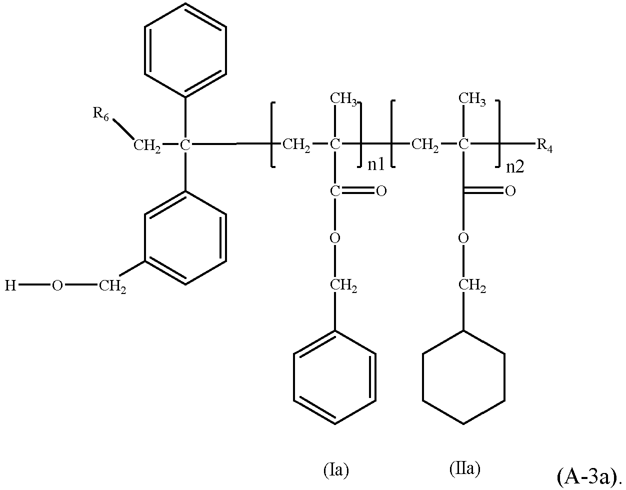

In another aspect of the inventive polymer of structure (A), as described herein, said polymer has structure (A-3b):

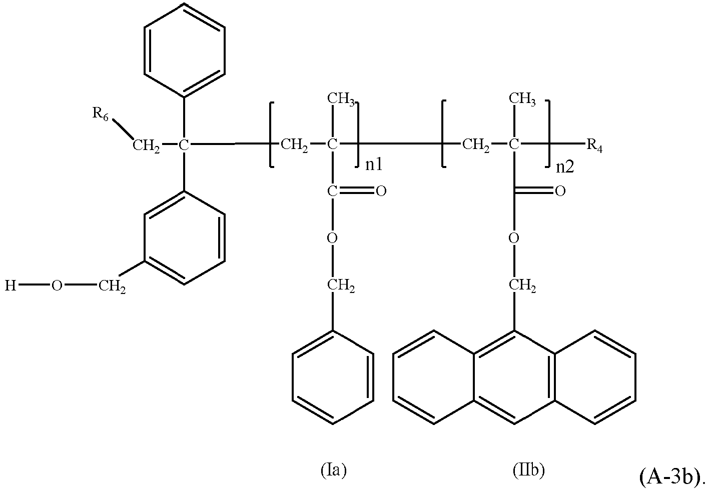

In another aspect of the inventive polymer of structure (A), as described herein, said polymer has structure (A-3c):

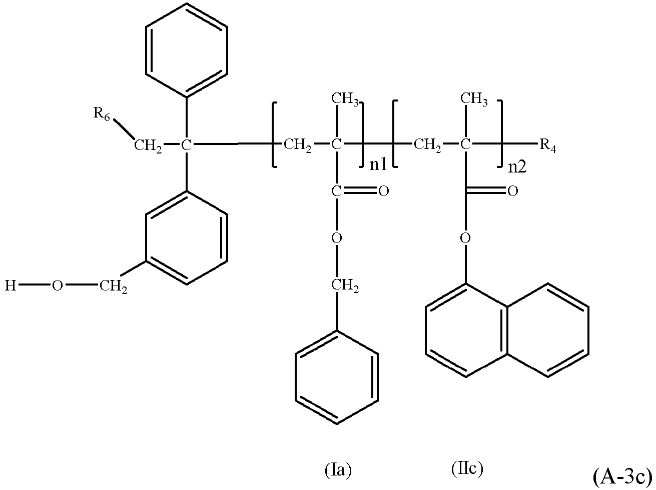

In another aspect of the inventive polymer of structure (A), as described herein, said polymer has structure (A-3d):

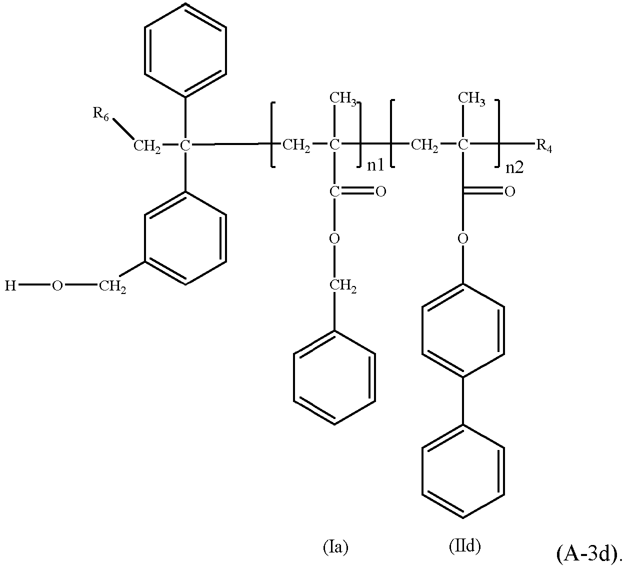

In another aspect of the inventive polymer of structure (A), as described herein, said polymer has structure (A-4). In one aspect of this embodiment R₂ is a C-1 to C-20 linear alkyl. In another aspect of this embodiment R₂ is a C-3 to C-20 branched alkyl. In still another aspect of this embodiment R₂ is a C-5 to C-20 cyclic alkyl:

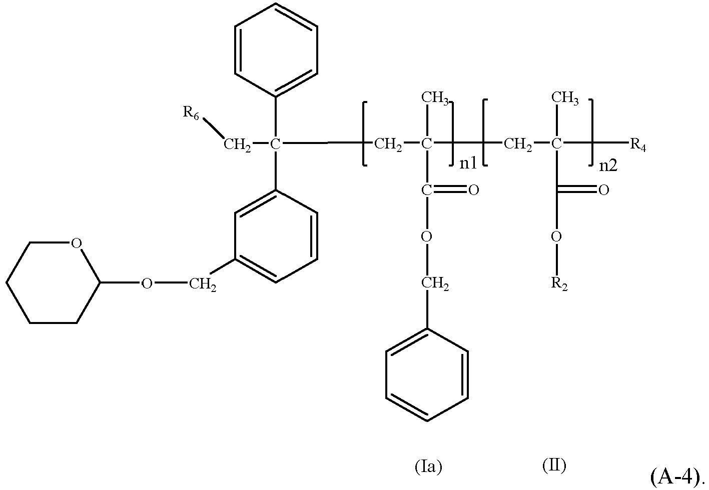

In another aspect of the inventive polymer of structure (A), as described herein, said polymer has structure (A-4a):

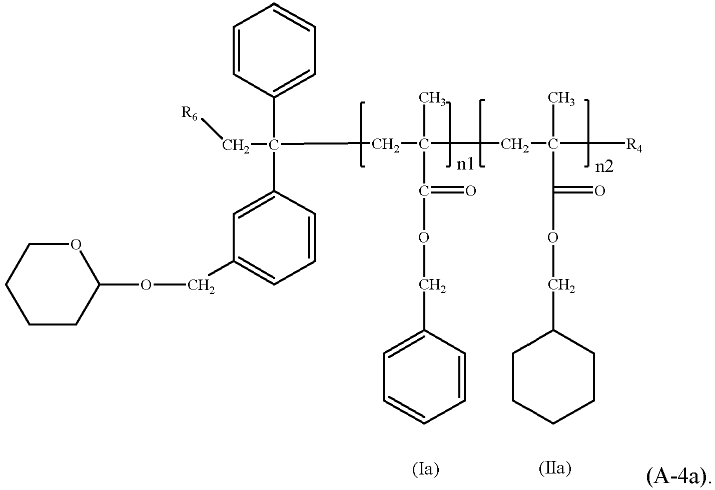

In another aspect of the inventive polymer of structure (A), as described herein, said polymer has structure (A-4b):

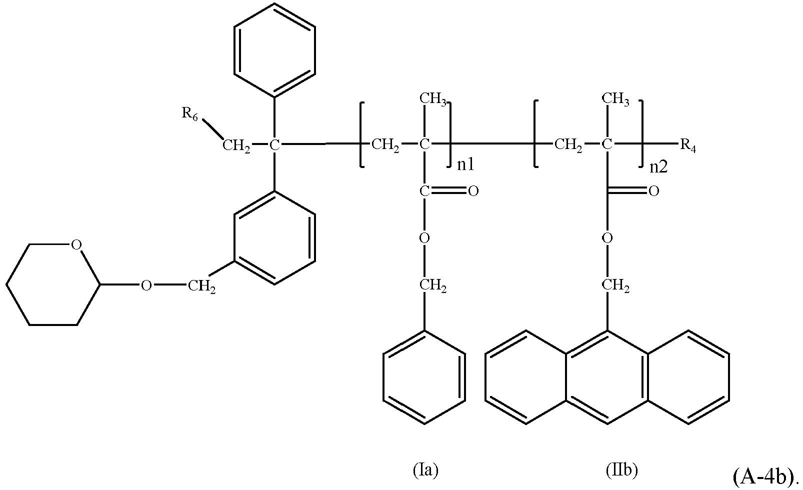

In another aspect of the inventive polymer of structure (A), as described herein, said polymer has structure (A-4c):

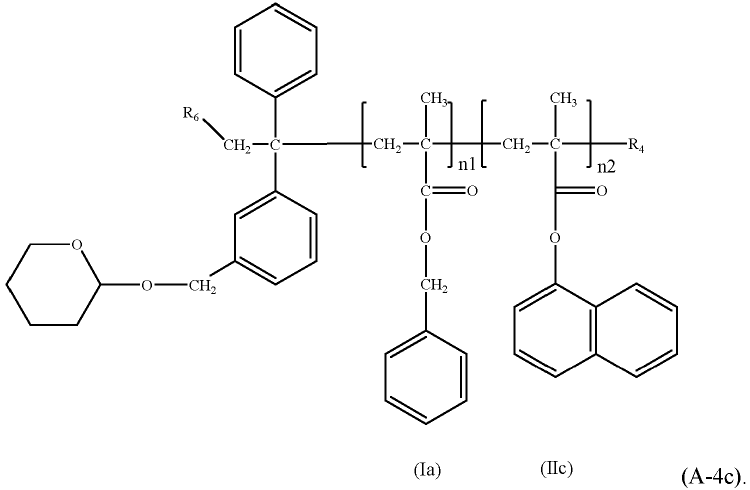

In another aspect of the inventive polymer of structure (A), as described herein, said polymer has structure (A-4d):

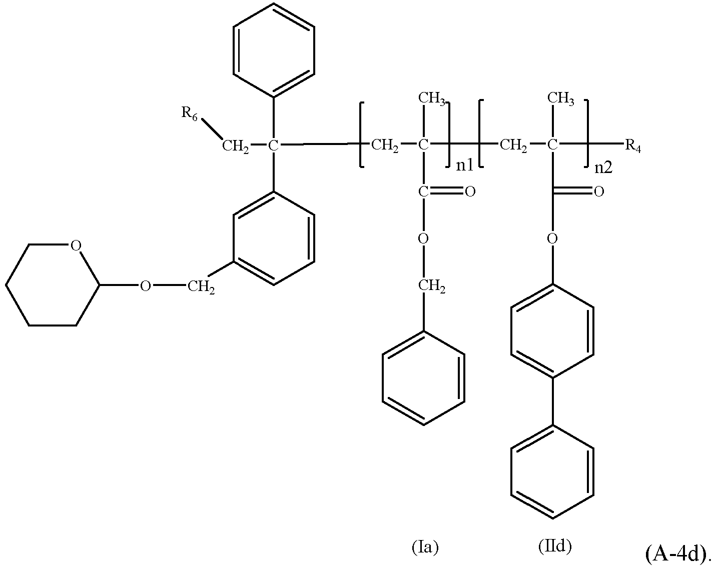

In another aspect of the inventive polymer of structure (A), as described herein, said polymer has structure (A-5). In one aspect of this embodiment, R₂ is a C-1 to C-20 linear alkyl. In another aspect of this embodiment R₂ is a C-3 to C-20 branched alkyl. In still another aspect of this embodiment R₂ is a C-5 to C-20 cyclic alkyl:

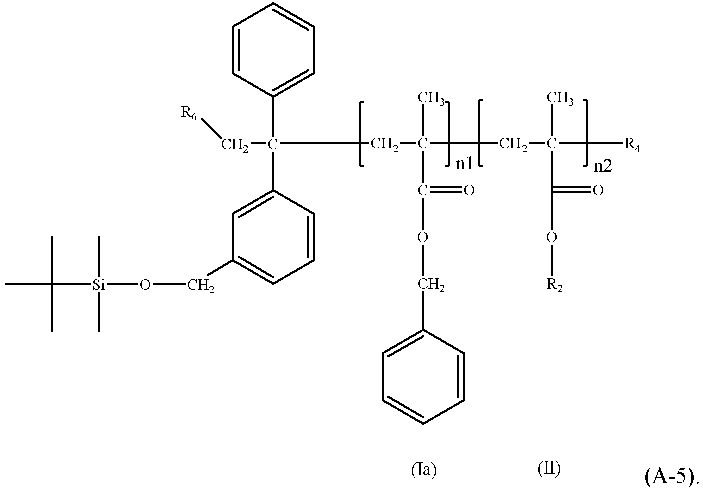

In another aspect of the inventive polymer of structure (A), as described herein, said polymer has structure (A-5a):

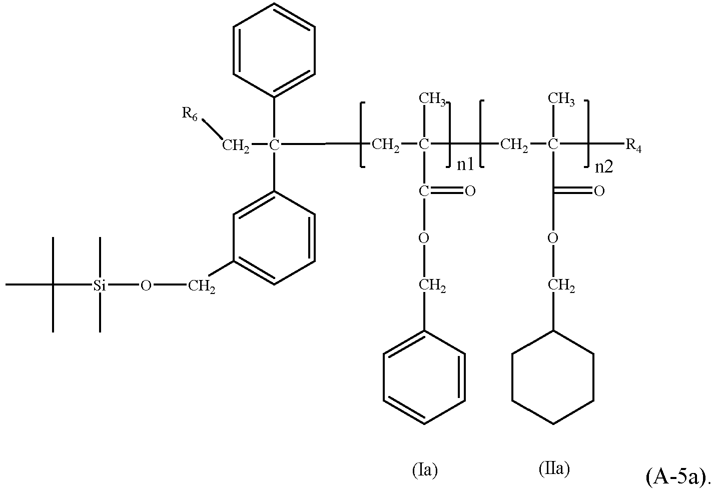

In another aspect of the inventive polymer of structure (A), as described herein, said polymer has structure (A-5b):

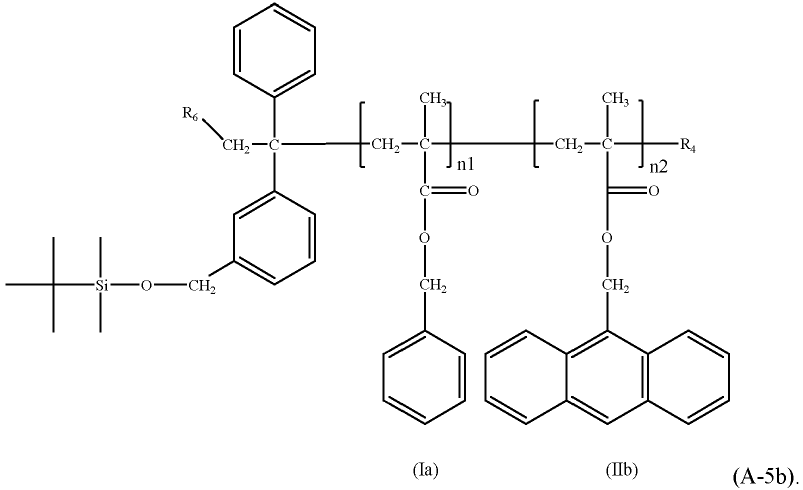

In another aspect of the inventive polymer of structure (A), as described herein, said polymer has structure (A-5c):

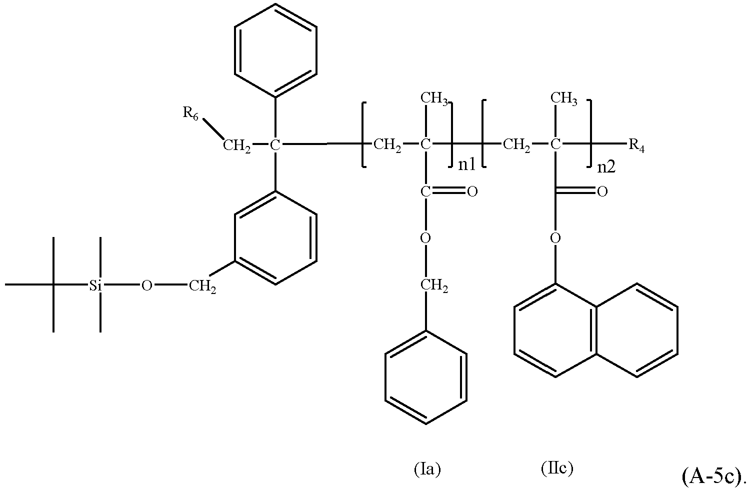

In another aspect of the inventive polymer of structure (A), as described herein, said polymer has structure (A-5d):

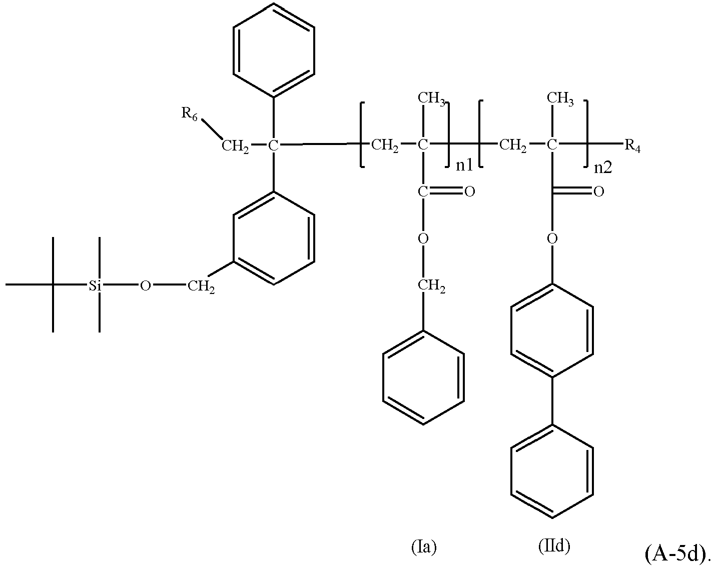

In another aspect of the inventive polymer of structure (A), as described herein, said polymer has structure (A-6):

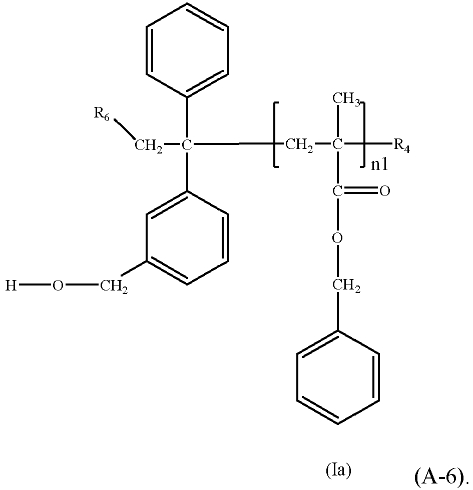

In another aspect of the inventive polymer of structure (A), as described herein, said polymer has structure (A-7):

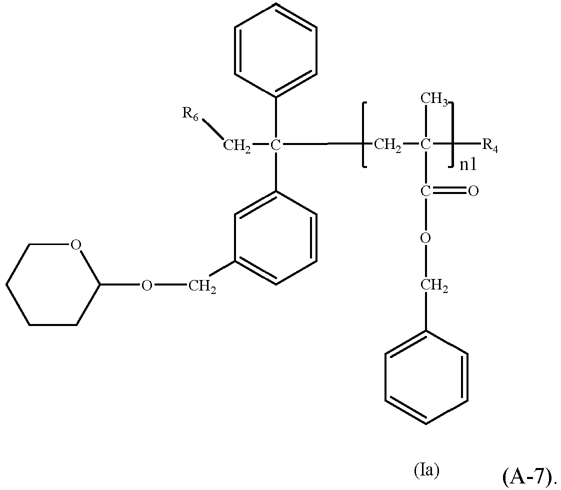

In another aspect of the inventive polymer of structure (A), as described herein, said polymer has structure (A-8):

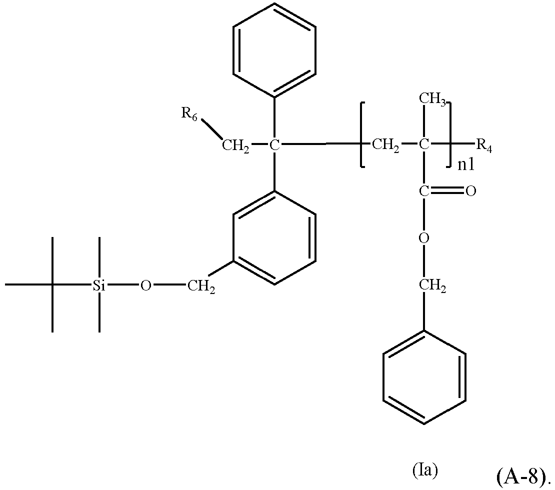

In another aspect of the inventive polymer of structure (A), as described herein, wherein it has structure (A-2), where R₄ has structure (IV) and R₃ is a moiety of structure (IIIa), L₂ is a C-2 to C-4 alkylene. In another aspect of this embodiment, L₂ is 1,3-propylene. In still another aspect of this embodiment, L₂ is ethylene. In another aspect of this embodiment, R₇ is H. In still another aspect of this embodiment, R₇ is an acetal protecting group. In yet another aspect of this embodiment, R₇ is a trialkylsilyl protecting group. In another aspect of this embodiment R₈ is C-1 to C-4 alkyl. In still another aspect of this embodiment, R₈ is H. In still another aspect of this embodiment Rₑ₃ is H. In still another aspect of this embodiment, Rₑ₃ is a C-1 to C-8 alkyl. In yet another aspect of this embodiment, Rₑ₃ is a C-1 to C-8 alkoxy. In still another aspect of this embodiment, R_{benz} is H. In still another aspect of this embodiment, R_{benz} is a C-1 to C-4 alkyl. In yet another aspect of this embodiment, R_{benz} is a C-1 to C-4 alkoxy.

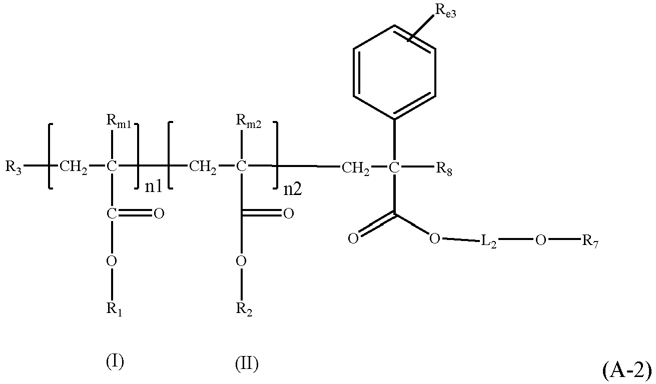

In another aspect of the inventive polymer of structure (A), as described herein, wherein it has structure (A-2), it has the more specific structure (A-9). In one aspect of this embodiment R₂ is a C-1 to C-20 linear alkyl. In another aspect of this embodiment, R₂ is a C-3 to C-20 branched alkyl. In still another aspect of this embodiment, R₂ is a C-5 to C-20 cyclic alkyl.

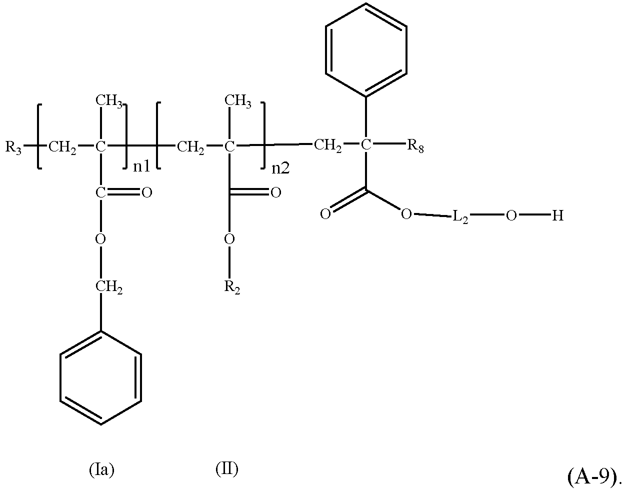

In another aspect of the inventive polymer of structure (A), as described herein, wherein it has structure (A-2), it has the more specific structure (A-9a):

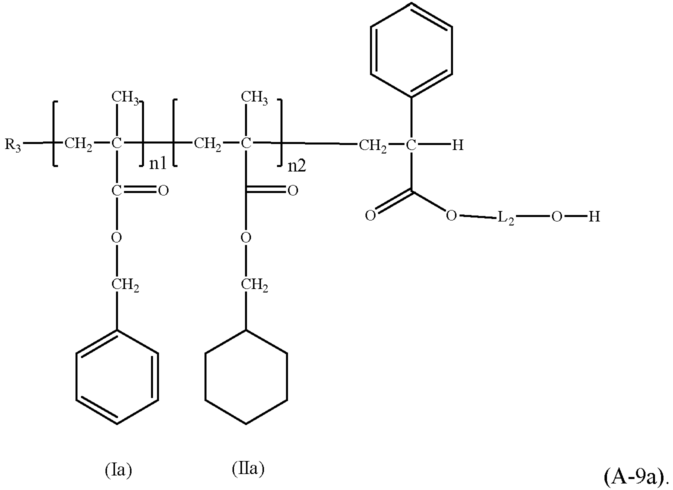

In another aspect of the inventive polymer of structure (A), as described herein, wherein it has structure (A-2), it has the more specific structure (A-9b):

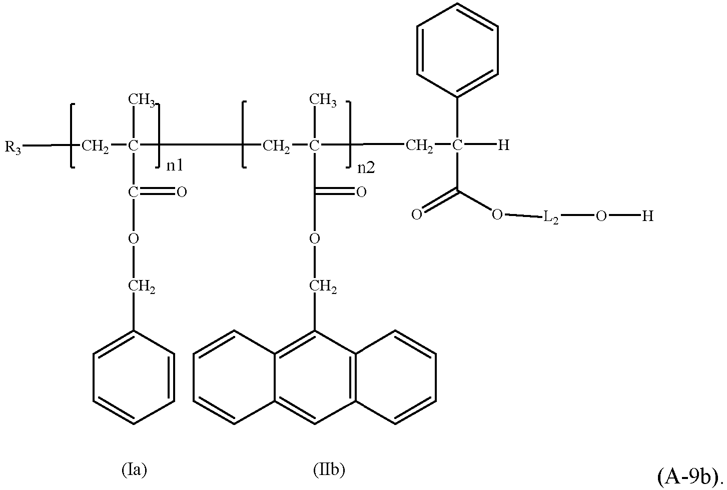

In another aspect of the inventive polymer of structure (A), as described herein, wherein it has structure (A-2), it has the more specific structure (A-9c):

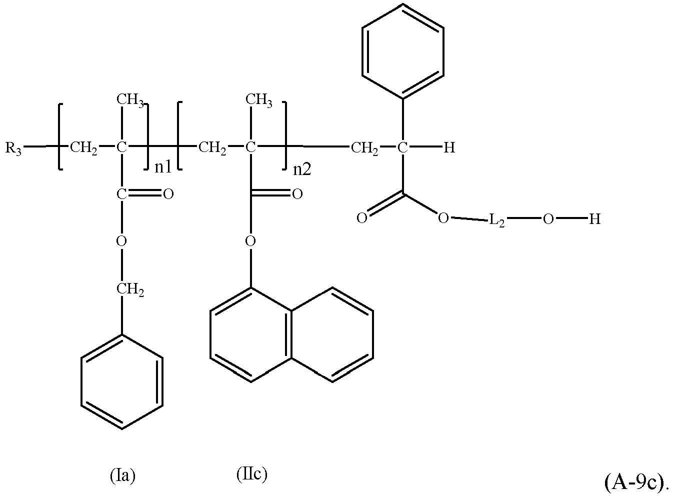

In another aspect of the inventive polymer of structure (A), as described herein, wherein it has structure (A-2), it has the more specific structure (A-9d):

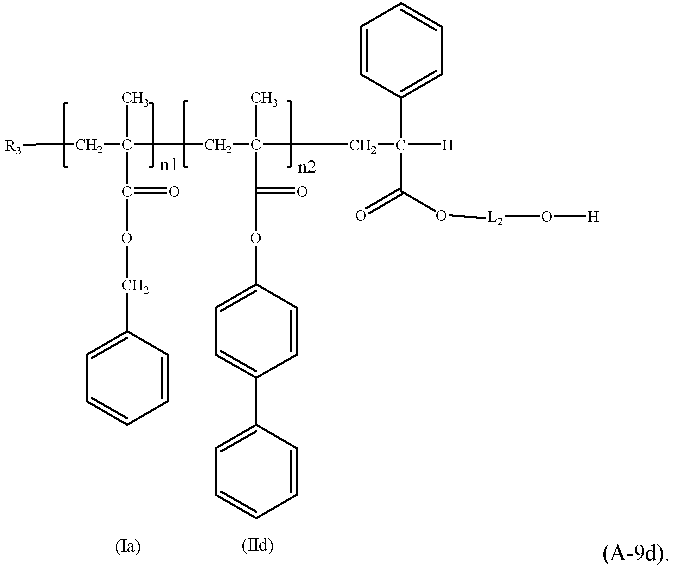

In another aspect of the inventive polymer of structure (A), as described herein, wherein it has structure (A-2), it has the more specific structure (A-10). In one aspect of this embodiment R₂ is a C-1 to C-20 linear alkyl. In another aspect of this embodiment R₂ is a C-3 to C-20 branched alkyl. In still another aspect of this embodiment R₂ is a C-5 to C-20 cyclic alkyl:

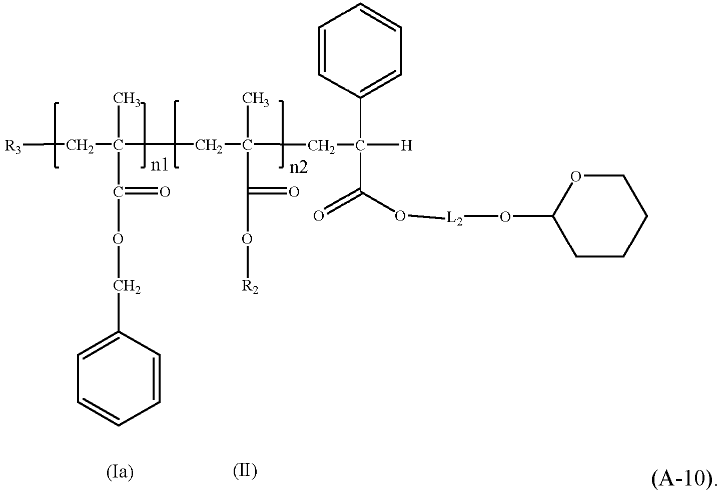

In another aspect of the inventive polymer of structure (A), as described herein, wherein it has structure (A-2), it has the more specific structure (A-10a)

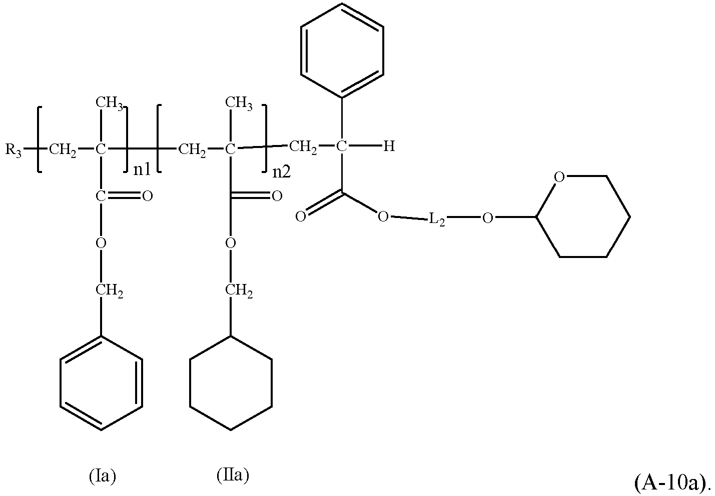

In another aspect of the inventive polymer of structure (A), as described herein, wherein it has structure (A-2), it has the more specific structure (A-10b):

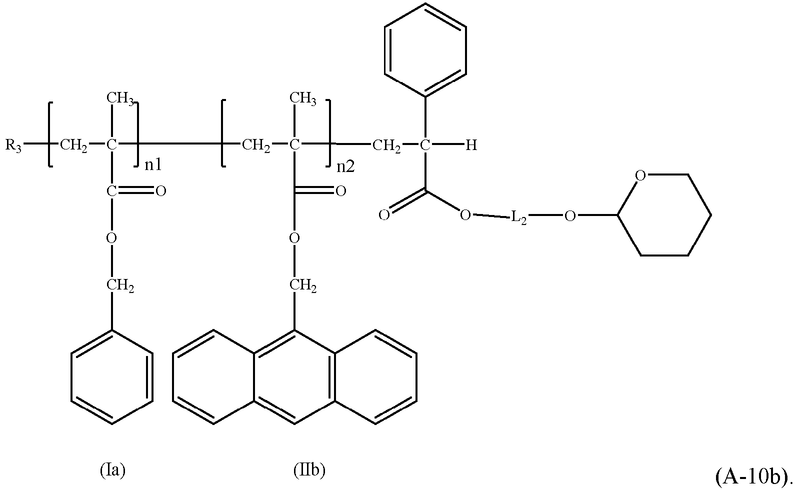

In another aspect of the inventive polymer of structure (A), as described herein, wherein it has structure (A-2), it has the more specific structure (A-10c):

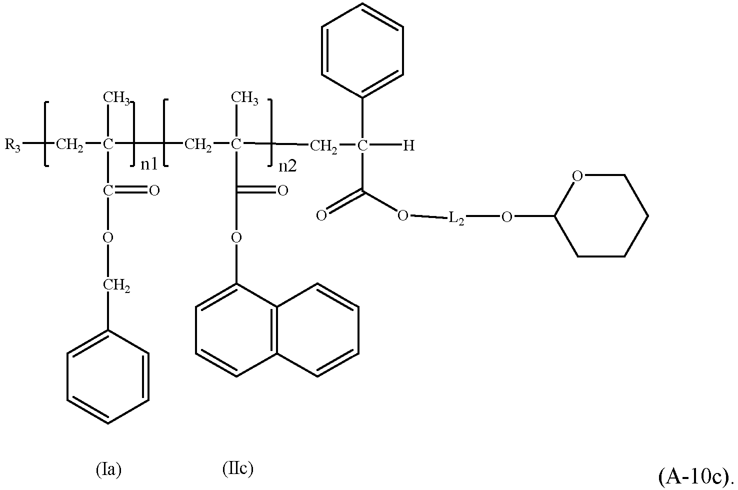

In another aspect of the inventive polymer of structure (A), as described herein, wherein it has structure (A-2), it has the more specific structure (A-10d):

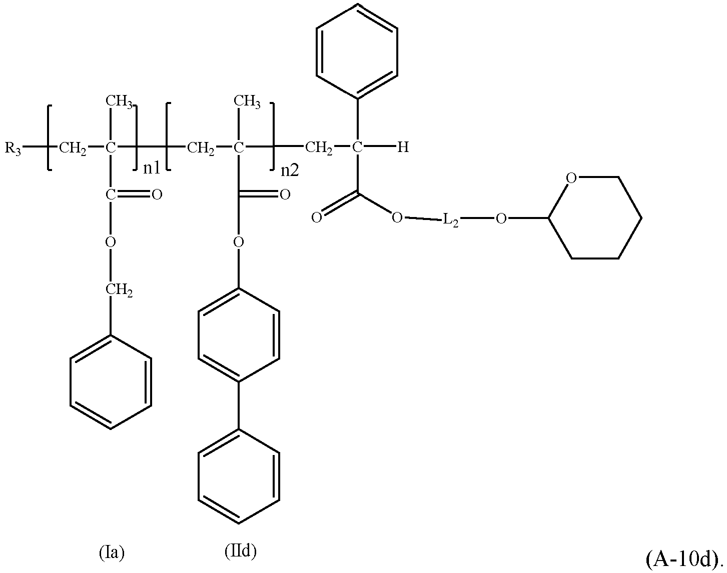

In another aspect of the inventive polymer of structure (A), as described herein, wherein it has structure (A-2), it has the more specific structure (A-11) In one aspect of this embodiment R₂ is a C-1 to C-20 linear alkyl. In another aspect of this embodiment R₂ is a C-3 to C-20 branched alkyl. In still another aspect of this embodiment R₂ is a C-5 to C-20 cyclic alkyl:

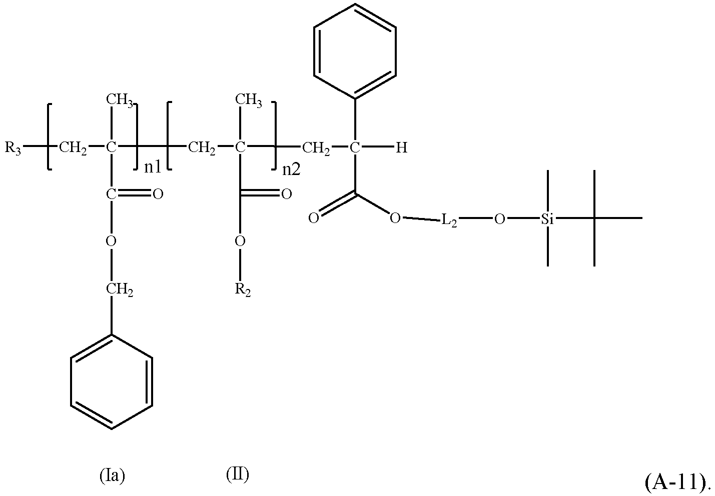

In another aspect of the inventive polymer of structure (A), as described herein, wherein it has structure (A-2), it has the more specific structure (A-11a):

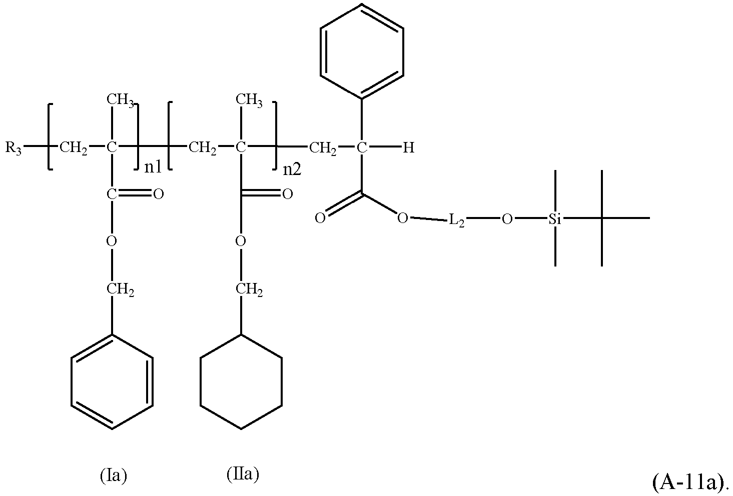

In another aspect of the inventive polymer of structure (A), as described herein, wherein it has structure (A-2), it has the more specific structure (A-11b):

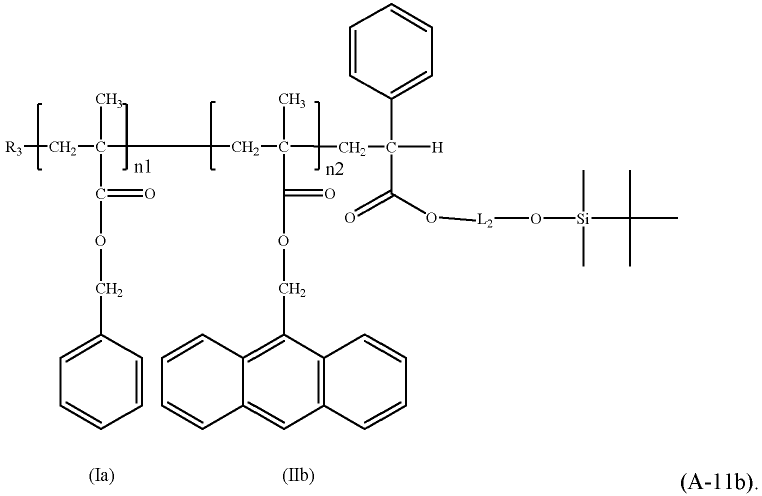

In another aspect of the inventive polymer of structure (A), as described herein, wherein it has structure (A-2), it has the more specific structure (A-11c):

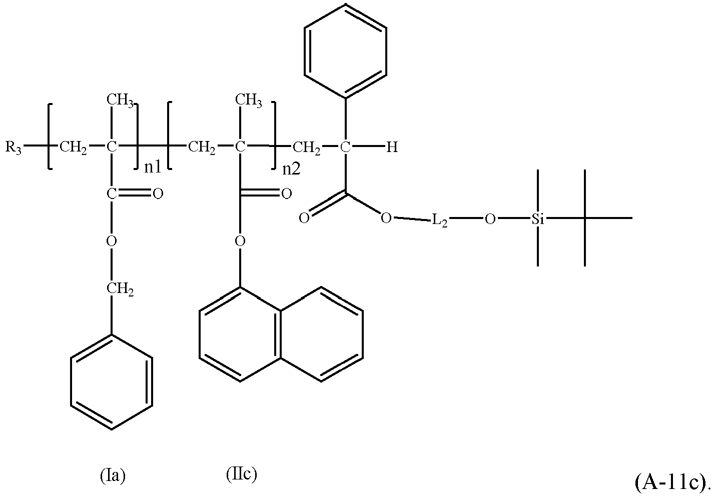

In another aspect of the inventive polymer of structure (A), as described herein, wherein it has structure (A-2), it has the more specific structure (A-11d):

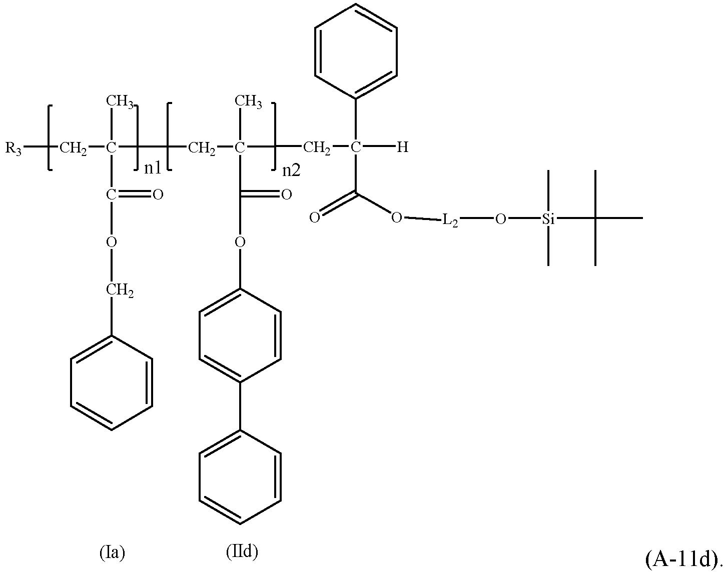

In another aspect of the inventive polymer of structure (A), as described herein, wherein it has structure (A-12):

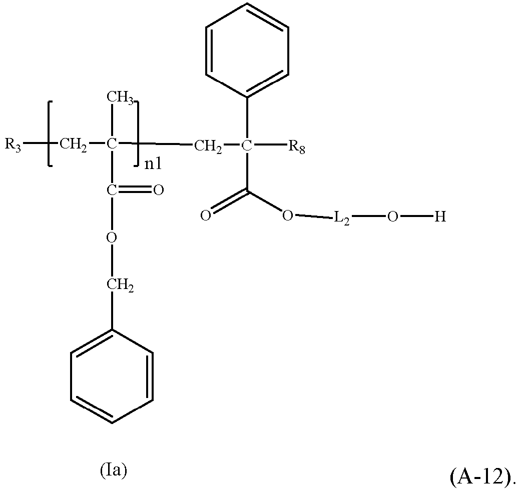

In another aspect of the inventive polymer of structure (A), as described herein, wherein it has structure (A-13):

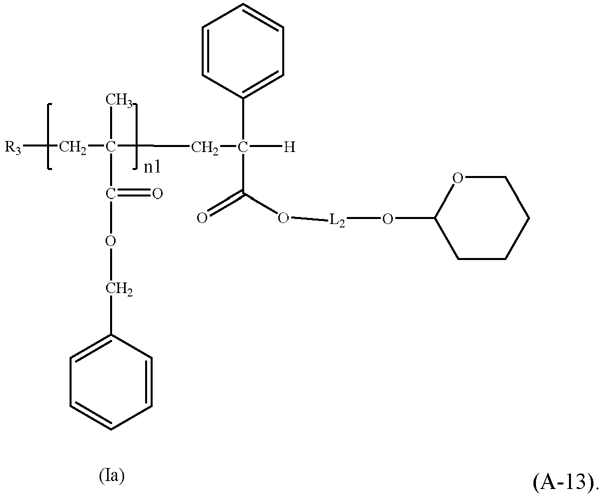

In another aspect of the inventive polymer of structure (A), as described herein, wherein it has structure (A-14):

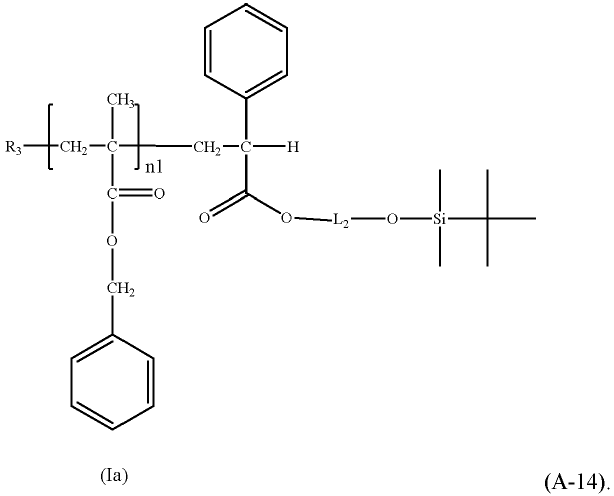

In another aspect of the inventive polymer of structure (A), as described herein, it is one having an Mₙ from about 500 to about 100,000. In another aspect of this embodiment, it is from about 500 to about 20,000.

In another aspect of the inventive polymer of structure (A), as described herein, it is one having a polydispersity from 1.0 to about 1.2. In another aspect of this embodiment, it has a polydispersity from 1.0 to about 1.1. In another aspect of this embodiment, it has a polydispersity from 1.0 to about 1.07. In still another aspect of this embodiment it has a polydispersity from 1.0 to about 1.05.

In another aspect of the inventive polymer of structure (A), as described herein, in which comprises both repeat units of structures (I) and (II), said repeat unit of structure (II) ranges from about 1 mole % to about 60 mole % of the total repeat units of structure (I) and (II). In another aspect of this embodiment said repeat unit of structure (II) ranges from about 5 mole % to about 50 mole % of the total repeat units of structure (I) and (II). In still another aspect of this embodiment said repeat unit of structure (II) ranges from about 7 mole % to about 40 mole % of the total repeat units of structure (I) and (II). In still another aspect of this embodiment said repeat unit of structure (II) ranges from about 9 mole % to about 40 mole % of the total repeat units of structure (I) and (II). In still another aspect of this embodiment said repeat unit of structure (II) ranges from about 10 mole % to about 30 mole % of the total repeat units of structure (I) and (II). In yet another aspect of this embodiment said repeat unit of structure (II) ranges from about 10 mole % to about 25 mole % of the total repeat units of structure (I) and (II). In another aspect of these embodiments, said repeat unit of structure (I) has the more specific structure (Ia). In still another aspect of these embodiments said repeat unit of structure (II) has the more specific structure (IIa). In still another aspect of these embodiments said repeat unit of structure (II) has the more specific structure (IIb). In yet another aspect of these embodiments, said repeat unit of structure (II) has the more specific structure (IIc). In still another aspect of these embodiments, said repeat unit of structure (II) has the more specific structure (IId). Compositions comprising a polymer of structure (A)

Another aspect of this invention is a composition comprising a polymer of structure (A) and its substructures, as described herein, and an organic spin casting solvent, wherein said polymer is one wherein either end group (III) is present and R₅ is H or end group (IV) is present R₇ is H. In one aspect of this embodiment, it is a composition which consists of these two components.

Suitable solvents for use for the inventive composition comprising a polymer of structure (A) and its substructures, as described herein, are any organic solvent which is employed to spin cast materials such as DSA materials, photoresist, bottom antireflective coatings or other types of organic coatings using the lithographic processing of semiconductor materials. In another aspect of said inventive compositions, the organic spin casting solvent is one which can dissolve said random polymers and any other additional optional components such as noted herein. This organic spin casting solvent may be a single solvent or a mixture of solvents. Suitable solvents are organic solvent which may include, for example, a glycol ether derivative such as ethyl cellosolve, methyl cellosolve, propylene glycol monomethyl ether (PGME), diethylene glycol monomethyl ether, diethylene glycol monoethyl ether, dipropylene glycol dimethyl ether, propylene glycol n-propyl ether, or diethylene glycol dimethyl ether; a glycol ether ester derivative such as ethyl cellosolve acetate, methyl cellosolve acetate, or propylene glycol monomethyl ether acetate (PGMEA); carboxylates such as ethyl acetate, n-butyl acetate and amyl acetate; carboxylates of di-basic acids such as diethyloxylate and diethylmalonate; dicarboxylates of glycols such as ethylene glycol diacetate and propylene glycol diacetate; and hydroxy carboxylates such as methyl lactate, ethyl lactate (EL), ethyl glycolate, and ethyl-3-hydroxy propionate; a ketone ester such as methyl pyruvate or ethyl pyruvate; an alkyloxycarboxylic acid ester such as methyl 3-methoxypropionate, ethyl 3-ethoxypropionate, ethyl 2-hydroxy-2-methylpropionate, or methylethoxypropionate; a ketone derivative such as methyl ethyl ketone, acetyl acetone, cyclopentanone, cyclohexanone or 2-heptanone; a ketone ether derivative such as diacetone alcohol methyl ether; a ketone alcohol derivative such as acetol or diacetone alcohol; a ketal or acetal like 1,3 dioxalane and diethoxypropane; lactones such as butyrolactone; an amide derivative such as dimethylacetamide or dimethylformamide, anisole, and mixtures thereof.

### Processes using the compositions comprising a polymer of structure (A)

### Process of forming a coating

Another aspect of this invention is a process for forming a grafted coating of a polymer on a substrate comprising the steps:
i) forming a coating of a composition comprising a polymer of structure (A), as describe herein in any one of its embodiments, on a substrate,
ii) heating the coating at a temperature from about 90°C to about 180°C to remove solvent. and to form a grafted coating of the polymer,
iii) heating the grafted coating of step ii) from about 200°C to about 250°C to form a fully cross-linked or fully crosslinked and grafted polymer coating.

### Process of forming a grafted neutral layer coating

Another aspect of this invention is a process for forming a grafted neutral layer coating on a substrate comprising the steps:
ia) forming a coating of a composition comprising a polymer of structure (A), as describe herein in any one of its embodiments, on a substrate
iia) heating the coating at a temperature from about 90°C to about 180°C to remove solvent and to form a grafted coating,
iiia) heating the grafted coating of step iia) at a temperature from about 200°C to about 250°C to form a fully grafted neutral layer coating.

### Process for forming a self-assembled block copolymer coating on a neutral layer coating

Another aspect of this invention is a process for forming a self-assembled block copolymer coating on a neutral layer coating comprising the steps:
ij) forming neutral layer coating according to the process of forming a grafted neutral layer coating as described above,
iij) applying a block copolymer over the neutral layer coating and annealing until directed self-assembly of the block copolymer coating occurs.

### Process of graphoepitaxy directed self-assembly of a block copolymer used to form an image

Another aspect of this invention is a process of graphoepitaxy, directed self-assembly of a block copolymer coating used to form an image comprising the steps:
ik) forming neutral layer coating according to the process of forming a grafted neutral layer coating as described above,
iik) providing a coating of a photoresist coating over the neutral layer coating,
   forming a pattern in the photoresist coating,
iiik) applying a block copolymer comprising an etch resistant block and a highly etchable block over the photoresist pattern and annealing until directed self-assembly occurs; and,
ivk) etching the block copolymer, thereby removing the highly etchable block of the copolymer overcoating areas of the substrate and simultaneously forming a pattern in the substrate selectively in these areas.

In one aspect of this process the pattern in the photoresist coating is formed by imaging lithography selected from a group consisting of e-beam, broadband, 193 nm immersion lithography, 13.5 nm EUV lithography, 193nm deep UV lithography, 248 nm deep UV lithography, 365 nm UV lithography and 436 nm UV lithography.

### Process of Chemoepitaxy directed self-assembly of a block copolymer used to form an image

Another aspect of this invention is a process of chemoepitaxy, directed self-assembly of a block copolymer coating used to form an image comprising the steps:
il) forming neutral layer coating according to the process of forming a grafted neutral layer coating as described above,
iil) providing a coating of a photoresist coating over the neutral layer coating,
   forming a pattern in the photoresist coating, thereby forming regions in which the neutral layer coating is uncovered by the resist,
iiil) treating the uncovered neutral layer coating to remove it, forming a pinning area,
ivl) removing the photoresist, uncovering the unaffected neutral layer coating forming a chemoepitaxy pattern containing neutral and pinning areas,
vl) applying a block copolymer comprising an etch resistant block and a highly etchable block over the neutral layer coating and annealing until directed self-assembly occurs; and,
vil) etching the block copolymer, thereby removing the highly etchable block of the copolymer overcoating areas of the substrate and simultaneously forming a pattern in the substrate selectively in these areas.

In one aspect of this process the pattern in the photoresist coating is formed by imaging lithography selected from a group consisting of e-beam, broadband, 193 nm immersion lithography, 13.5 nm EUV lithography, 193nm deep UV lithography, 248 nm deep UV lithography, 365 nm UV lithography and 436 nm UV lithography.

Another aspect of this invention is the use of the polymer of structure (A) as described herein in any one of its embodiments, or of the composition as described herein, in a process for preparing a grafted coating or a self-assembled coating on a substrate.

### EXAMPLES

### Chemicals

All chemicals are available from Millipore-Sigma unless otherwise noted. 9-Anthracenemethyl methacrylate is available from Shanghai B&C. NMR was measured by a Bruker 400 MHz Avance III spectrometer in CD₂Cl₂. GPC was measured using Agilent system.

All synthetic experiments were carried out under N₂ atmosphere. Lithographic experiments were carried out as described in the text. The molecular weight of the polymers was measured with a Gel Permeation Chromatograph.

Unless indicated otherwise, ¹H NMR spectra were recorded using Bruker Advanced III 400 MHz spectrometer in CD₂Cl₂.

Lithographic Experiments were done using a TEL Clean ACT8 track. SEM pictures were taken with an applied Materials NanoSEM_3D Scanning electron microscope picture are shown at either 1 FOV magnification or 2 FOV magnification (Field of view (FOV) = 5 µm using 1, 2, and 5 FOV).

Etching experiments were done using standard isotropic oxygen etching conditions for self-assembled films block copolymer of methyl methacrylate and styrene.

Unless otherwise indicated Molecular weight measurements (a.k.a. Mₙ polydispersity) were done by Gel permeation chromatography (PSS Inc. Germany) equipped with 100Å, 500 Å, 10³ Å, 10⁵ Å and 10⁶ Å µ-ultrastyragel columns using THF solvent as an eluent. Polystyrene polymer standards were used for calibration.

Herein the titration reagent "secbutylDPE-Li," is defined as adduct of sec-butyl lithium and 1,1'-diphenylethylene (DPE) prepared by adding an equimolar amount of sec-butyl lithium to a 2 wt. % solution of DPE in toluene.

Experiments are given below as examples. Unless indicated otherwise, all the polymers synthesized in this disclosure were characterized by Gel permeation chromatography (PSS Inc. Germany) equipped with 100Å, 500 Å, 10³ Å, 10⁵ Å and 10⁶ Å µ-ultrastyragel columns using THF solvent as an eluent (1mL/min) for molecular weight measurements (M_{n,GPC}, and M_{w,GPC}) and polydispersity indices using polystyrene standards for calibration as a reference. Composition of polymers and end-functionality were determined using 300 MHz ¹H- NMR in CD₂Cl₂. Coating studies were performed using blanket dielectric as well as metal coupons. The films were baked at desired temperature and time and rinsed with excess material.

### Synthesis of Polymeric Materials for Testing

### Reference Polymer Synthesis Example Synthesis of P(S-b-MMA) (26k-b-30k)

P(S-b-MMA) (26K-b-30K) was synthesized using the same procedure as described in example 2. To achieve target Mₙ and compositions of PS and PMMA block, the amount of initiator and monomer quantities were changed. 20 g (0.192 moles) of styrene was polymerized by rapidly adding 0.55 mL (1.4M solution) of sec-butyllithium. Then 0.164 g (0.0007 moles) of 1,1'-diphenylethylene (DPE) in 2.5 ml of dry toluene was added via ampule into the reactor. The orange color of the reaction mixture turned into dark brick-red indicating conversion of styryllithium active centers to delocalized DPE adduct carbanion. After 2 min of stirring, a small amount (2 mL) of the reaction mixture was withdrawn for PS block molecular weight analysis. Then methyl methacrylate (22.85 g, 0.23 moles) was added via ampule. The reaction was terminated after 30 min with 1 mL of degassed methanol. The block copolymer was recovered by precipitation in excess isopropanol (5 times of the polymer solution) containing 10 % water, filtered, and dried at 55°C for 12 h under vacuum giving 40 g of P(S-b-MMA) (94 % yield) consisting of 46.9 mol. % of polystyrene block and 53.1 mol. % of polymethylmethacrylate block.Gel permeation chromatography equipped with 100Å, 500 Å, 10³ Å, 10⁵ Å and 10⁶ Å µ-ultrastyragel columns showed that the 1^{st} P(SDPE) block had Mₙ (GPC) = 45,048 g/mol and M_{w}/Mₙ = 1.04 with respect to PS calibration standards. The diblock copolymer molecular weight obtained from GPC is M_{n,PS-b-PMMA} = 46,978 g/mol and M_{w}/Mₙ = 1.02.

### Example 1 Synthesis of hydroxy methyl terminated-poly(benzyl methacrylate-co-[1,1'-biphenyl]-4-ylmethyl methacrylate)

[1,1'-Biphenyl]-4-ylmethyl methacrylate [1,1'-biphenyl]-4-yl methacrylate (BPMMA, 3.76g, 14.9 mmol) was weighed into a calibrated ampule and dissolved in toluene (8.0 mL). Benzyl methacrylate (BnMA, 10.1 ml, 59.6 mmol) was added via syringe into the ampule. The mixture was degassed under reduced pressure (10⁻⁶ mmHg) until toluene (8.0 ml) was removed from monomer mixture. In the glovebox, Tetrahydropyran (THP) protected 3-(hydroxy methyl)-1,1-diphenyl ethylene (MTAG-8, 0.72 g, 2.45 mmol) was weighed (1.2 molar excess with respect to s-BuLi) in a vial and dissolved in 3 mL toluene. This solution was promptly titrated with dilute secbutylDPE-Li solution until an orange color was persistence. Solution color got weaker and then changed to green by the time it was added to the reactor. After closing the stopcock ampule was removed from glovebox. Both BnMA/BPMMA ampule and MTAG-8 ampule were attached to the flaks using glass joints and yellow grease Required amount of LiCl (5 times excess with respect to s-BuLi) weighed and quickly added to the flask and closed with three-way septum adaptor, which was connected with a rubber tubing for access to vacuum/argon. Vacuum was applied to the flask and LiCl was dried using heat-gun. After 10 min flask was brought to RT and filled with argon. Under positive pressure ~150 mL dry THF was transferred to the flask via cannula transfer. The flask temperature was lowered to -78°C using dry ice/acetone bath. LiCl/THF and the solution was titrated with s-BuLi (3 ml, 1.4M) until a persistent lemon yellow/yellow was obtained. After 5 min dry ice/acetone bath was removed and flask was brought to RT. It takes 15-30 min for the complete decay of yellow color. After a colorless solution was obtained, flask temperature was lowered to -78°C and the titrated MTAG-8 solution was added by opening stopcock. The colorless mixture turned pale orange after the addition of the MTAG-8. The required amount of s-BuLi (1.46 mL, 2.04 mmol, 1.4M) to generate active MTAG-8 initiator was added using airtight glass syringe. This results in color change from pale orange to dark red, a color of active MTAG-8/Li initiator. After 2-3 min, initiator solution kept under stirring at 300 rpm and BnMA/BPMMA mixture was added dropwise for 10 minutes. Propagation was continued further for 110 minutes and terminated with 2 mL degassed methanol and brought to RT. MeOH (80 - 100 ml) was added to the solution, followed by adding pTSA (4.7g, 10-fold-excess amount). The reaction mixture was stirred at room temperature for overnight. The mixture was precipitated in a large amount of methanol and polymer was recovered by vacuum filtration. The dried polymer was dissolved in EtOAc as a 10% solids solution, washed 3 times with 1 wt. % ascorbic acid (aq), and then 3 times DI water. The organic mixture was precipitated in hexanes (8 parts volume) and the precipitate was collected by vacuum filtration and dried in a vacuum oven at 60 °C. Quantitative yield of P(BnMA-co-BPMMA)-DPE-CH2OH was obtained.

Table 1 shows a summary of the reaction conditions and characterization for polymers containing BPMMA Exampled 1, 1a and 1b (Scheme 1). Examples 1a and 1b used the same procedure as Example but varied the loading of loading BPMMA Example 1a (2X times), Examples 1b (2.5X). This was reflected in the amount of BPMMA incorporated into the polymer as a repeat unit in Table 1 as measured by proton NMR in CD₂Cl₂.

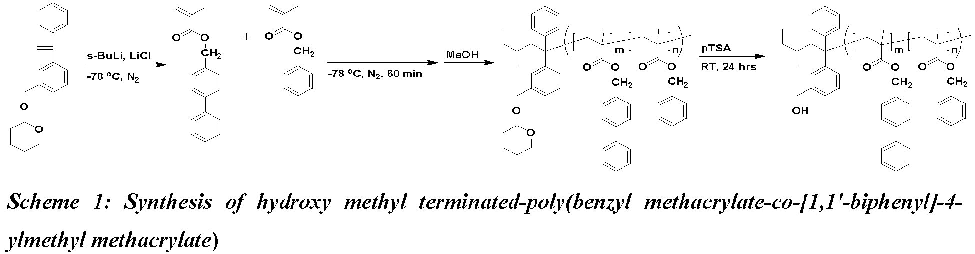

**Table 1. Synthesis of copolymers with different contents of BPMMA**

| **Exa mpl es** | **Reaction Condition [C]or [I]/Temp/time/** [reagent] mol/L | **Grams / Yield %** | **Mn/PDI** | **¹H-NMR Mole % BPMMA repeat unit** |
|---|---|---|---|---|
| 1 | 10 wt. % / -78°C / 120min | 16.0 g / 99.3% | 7.0K / 1.03 | 10% BPMMA |
| 1a | 10 wt. % / -78°C / 120min | 14.9 g / 99.0% | 7.4K / 1.06 | 20% BPMMA |
| 1b | 10 wt. % / -78°C / 120min | 15.3 g / 99.5% | 12.7K/1.04 | 25% BPMMA |

**Example** 2. Synthesis of hydroxy methyl terminated-poly(benzyl methacrylate-co-cyclohexyl methacrylate) Cyclohexyl methacrylate (CHMA, 5 ml, 28.7 mmol) and benzyl methacrylate (BnMA, 14.6 ml, 86.1 mmol) was added via syringe into the ampule. The mixture was degassed under reduced pressure (10⁻⁶ mmHg) until toluene (8.0 ml) was removed from monomer mixture. In the glovebox, Tetrahydropyran (THP) protected 3-(hydroxy methyl)-1,1-diphenyl ethylene (MTAG-8, 0.71 g, 2.4 mmol) was weighed (1.2 molar excess with respect to s-BuLi) in a vial and dissolved in 3 mL toluene. This solution was promptly titrated with dilute secbutylDPE-Li solution until an orange color was persistence. Solution color got weaker and then changed to green by the time it was added to the reactor. After closing the stopcock ampule was removed from glovebox. Both BnMA/BPMMA ampule and MTAG-8 ampule were attached to the flaks using glass joints and yellow grease Required amount of LiCl (5 times excess with respect to s-BuLi) weighed and quickly added to the flask and closed with three-way septum adaptor, which was connected with a rubber tubing for access to vacuum/argon. Vacuum was applied to the flask and LiCl was dried using heat-gun. After 10 min flask was brought to RT and filled with argon. Under positive pressure ~150 mL dry THF was transferred to the flask via cannula transfer. The flask temperature was lowered to -78°C using dry ice/acetone bath. LiCl/THF and the solution was titrated with s-BuLi (3 ml, 1.4M) until a persistent lemon yellow/yellow was obtained. After 5 min dry ice/acetone bath was removed and flask was brought to RT. It took 15-30 min for the complete decay of yellow color. After a colorless solution was obtained, flask temperature was lowered to -78°C and the titrated MTAG-8 solution was added by opening stopcock. The colorless mixture turned pale orange after the addition of the MTAG-8. The required amount of s-BuLi (1.43 mL, 2.0 mmol, 1.4M) to generate active MTAG-8 initiator was added using airtight glass syringe. This results in color change from pale orange to dark red, a color of active MTAG-8/Li initiator. After 2-3 min, initiator solution kept under stirring at 300 rpm and BnMA/BPMMA mixture was added dropwise for 10 minutes. Propagation was continued further for 110 minutes and terminated with 2 mL degassed methanol and brought to RT. MeOH (80 - 100 ml) was added to the solution, followed by adding pTSA (3.8 g, 10-fold-excess amount). The reaction mixture was stirred at room temperature for overnight. The mixture was precipitated in a large amount of methanol and polymer was recovered by vacuum filtration. The dried polymer was dissolved in EtOAc as a 10% solids solution, washed 3 times with 1 wt. % ascorbic acid (aqueous, aq), and then 3 times DI water. The organic mixture was precipitated in hexanes (8 parts volume) and the precipitate was collected by vacuum filtration and dried in a vacuum oven at 60 °C. Quantitative yield of P(BnMA-co-BPMMA)-DPE-CH₂OH was obtained. Table 2 shows a summary of the reaction conditions used for Example 2 (Scheme 2) and the characterization of the polymer obtained which contained a repeat unit derived from CHMA.

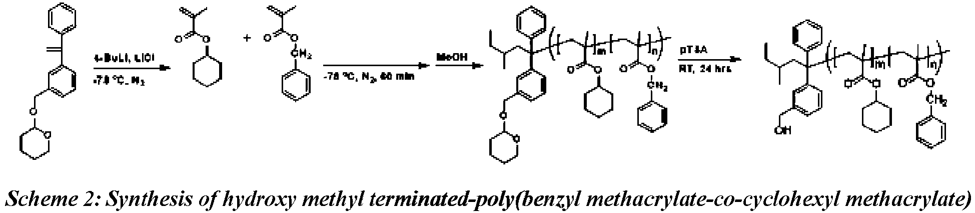

**Table 2. Synthesis of polymer containing CHMA**

| **Example** | **Reaction Condition [C]or [I]/Temp/time/** [reagent] mol/L | **Grams / Yield %** | **Mn/PDI** | **¹H-NMR Mole % CHMA** |
|---|---|---|---|---|
| 2 | 25 wt. % / -78°C / 120min | 20.0 g / 100% | 23.0K / 1.04 | 25% CHMA |

### Example 3. Synthesis of hydroxy methyl terminated-poly(benzyl methacrylate-co-9-anthracenyl methyl methacrylate)

9-Antracenyl methyl methacrylate (AMMA, 3.11g, 11.3 mmol) was weighed into a calibrated ampule and dissolved in toluene (6.0 mL). Benzyl methacrylate (BnMA, 17.1 ml, 100.9 mmol) was added via syringe into the ampule. The mixture was freeze-thawed 3 times to degas the mixture. In the glovebox, Tetrahydropyran (THP) protected 3-(hydroxy methyl)-1,1-diphenyl ethylene (MTAG-8, 0.77 g, 2.42 mmol) was weighed (1.2 molar excess with respect to s-BuLi) in a vial and dissolved in ~3-5 mL toluene. This solution was promptly titrated with dilute secbutylDPE-Li solution until an orange color was persistence. Solution color got weaker and then changed to green by the time it was added to the reactor. After closing the stopcock ampule was removed from glovebox. Both BnMA/AMMA ampule and MTAG-8 ampule were attached to the flaks using glass joints and yellow grease. Required amount of LiCl (5 times excess with respect to s-BuLi) weighed and quickly added to the flask and closed with three-way septum adaptor, which was connected with a rubber tubing for access to vacuum/argon. Vacuum was applied to the flask and LiCl was dried using heat-gun. After 10 min flask was brought to RT and filled with argon. Under positive pressure ~250 mL dry THF was transferred to the flask via cannula transfer. The flask temperature was lowered to -78°C using dry ice/acetone bath. LiCl/THF and the solution was titrated with s-BuLi (3 ml, 1.4M) until a persistent lemon yellow/yellow was obtained. After 5 min dry ice/acetone bath was removed and flask was brought to RT. It takes 15-30 min for the complete decay of yellow color. After a colorless solution was obtained, flask temperature was lowered to -78°C and the titrated MTAG-8 solution was added by opening stopcock. The colorless mixture turned pale orange after the addition of the MTAG-8. The required amount of s-BuLi (1.46 mL, 2.33 mmol, 1.4M) to generate active MTAG-8 initiator was added using airtight glass syringe. This results in color change from pale orange to dark red, a color of active MTAG-8/Li initiator. After 2-3 min, initiator solution kept under stirring at 300 rpm and BnMA/AMMA mixture was added dropwise for 10 minutes. Propagation was continued further for 110 minutes and terminated with 2 mL degassed methanol and brought to RT. MeOH (15 ml) was added to the solution, followed by adding pTSA (2.23g, 5.0-fold-excess amount). The reaction mixture was stirred at room temperature for overnight. The mixture was precipitated in a large amount of methanol and polymer was recovered by vacuum filtration. The dried polymer was dissolved in EtOAc as a 10% solids solution, washed 3 times with 1 wt. % ascorbic acid (aq), and then 3 times DI water. The organic mixture was precipitated in hexanes (8 parts volume) and the precipitate was collected by vacuum filtration and dried in a vacuum oven at 70 °C. Quantitative yield of P(BnMA-co-AMMA)-DPE-CH2OH was obtained. Table 3 shows a summary of the reaction conditions and characterization for polymers containing AMMA Exampled 3, 3a, 3b, and 3c (Scheme 3). Examples 3a to 3c used the same procedure as Example but in increase the loading of AMMA Example 3a (3 X times), Examples 3b (4.36 X times) Examples 3c(4.11 X times). This was reflected in the amount of BPMMA incorporated into the polymer as a repeat unit in Table 1 as measured by proton NMR in CD₂Cl₂.

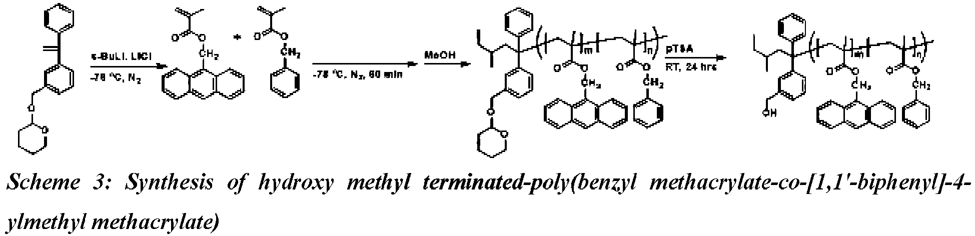

**Table 3. Product synthesis history**

| **Examples** | **Reaction Condition [C]or [I]/Temp/time/** [reagent] mol/L | **Grams / Yield %** | **Mn/PDI** | **¹H-NMR Mole % AMMA** |
|---|---|---|---|---|
| 3 | 3 wt. % / -78 °C / 30min | 20.0 g / 95% | 8.0k / 1.06 | 4.7% AMMA |
| 3a | 3 wt. % / -78 °C / 30min | 20.5 g / 92% | 6.1k / 1.09 | 14.1% AMMA |
| 3b | 3 wt. % / -78 °C / 30min | 20.6 g / 91% | 6.9kk/1.11 | 20.5% AMMA |
| 3c | 3 wt. % / -78 °C / 30min | 13.5 g / 93% | 7.1k/1.09 | 17.7% AMMA |

### Preparation of polymer formulation:

The polymers described here were separately dissolved in PGMEA to form 1 wt. % solutions. These solutions where individually filtered in using a Nylon filter (Entegris, Billerica, Ma). These solutions were separately coated at 1500 rpm on both metal (Cu, W) and SiO₂ wafers, and the wafers were subsequently baked at 230°C for 5 min. Following the bake, the wafers were rinsed with PGMEA for 2 min to remove any un-grafted polymer from the wafer which were then spun dried by spinning "1,500 rpm," followed by baking at 110°C for 1 min. Then water contact angle, was measured to understand the grafting efficiency and the results were shown in Table 1. Subsequently, the second brush of hydroxyl terminated PS-OH or PMMA-OH containing polymer formulation was made in PGMEA at 1 wt. solid. Then after filtering with 0.25-micron Nylon filter, the solution was spin coated on to previously brushed metal and SiO2 substrates. After baking at various temp. and time, the double brushed substrates were rinsed to remove unreacted second brushes. Then the double brushed substrates were examined by WCA and XPS to understand cross-grafting to judge the first brush's efficiency and selectivity to metal substrates.

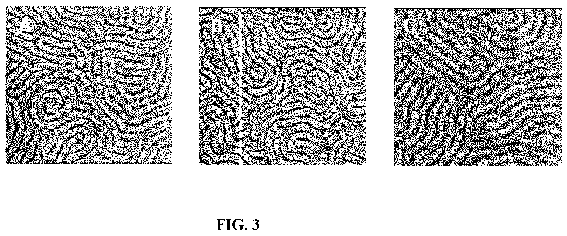

FIG. 3 shows a 1FOV SEM images of each fingerprint pattern on a silicon wafer using A) PS-b-PMMA on P(BnMA-r-BPMA_{25%})-OH (Mn: 13K, brush FT: 4.2 nm ± 0.3, WCA: 81.0 ± 2.3) B) PS-b-PMMA on P(BnMA-r-CHMA_{25%})-OH(Mn: 23K, brush FT: 3.8 nm ± 0.3, WCA: 79.4 ± 0.5) C) PS-b-PMMA on P(BnMA-r-AMMA_{20%}-OH) (Mn: ~ 7.0K, brush FT: 7.9 nm ± 0.3, WCA: 80.8 ± 0.5). Process conditions: Si wafer, coat NLD, 200°C/ 30 min/ N2 (Polymer A, B, & C, 230°C), 15 min toluene soak, N2 blow dry, PME-7167 Ctg65: L₀ = 48 nm, FT = 50 nm, 270° C/1 h (N₂).

## Claims

1. A random polymer of structure (A), comprising
a repeat unit of structure (I), where Rₘ₁ is a C-1 to C-8 alkyl, R₁ is a benzylic comprising moiety of structure (V) wherein R_{benz} is a substituent individually selected from H, a C-1 to C-4 alkyl, and a C-1 to C-4 alkoxy, L₃ is a C-1 to C-4 alkylene, and "*" designates the attachment point of this substituent to this repeat unit, and n1 designates the number of this repeating unit in the polymer, and further where the mole % of this repeat unit is from about 40 mole % to about 100 mole %,
a repeat unit of structure (II), wherein, Rₘ₂ is a C-1 to C-8 alkyl, R₂ is a moiety selected from a C-1 to C-20 linear alkyl, a C-3 to C-20 branched alkyl, and a C-5 to C-20 cyclic alkyl, a cyclohexylalkylene moiety of structure (VI), an anthracenylalkylene moiety of structure (VII), a naphthalenylalkylene moiety of structure (VIII), and a biphenyl moiety of structure (VIV), wherein L₄ and L₅ are independently selected from a C-1 to C-4 alkylene, L₆ and L₇ are independently selected from a direct valence bond or a C-1 to C-4 alkylene moiety, R_{cycl}, Rₐₙₜₕ, Rₙₐₚₕ, R_{biph}, are substituents individually selected from H, a C-1 to C-4 alkyl, and a C-1 to C-4 alkoxy, n2 designates the number of this repeating unit in the polymer, and further where the mole % of this repeat unit is from about 0 mole % to about 60 mole %, and further wherein the total mole % of the repeat units in said polymer of repeat units of structures (I) and (II) is 100 mole %;
two end groups R₃ and R₄, wherein
end group R₃, which is derived from an anionic initiator, wherein R₃ is either a moiety of structure (IIIa), or is a moiety of structure (III), wherein L₁ is a C-1 to C-8 alkylene, and R₅ is H, an acetal protecting group, or a trialkylsilyl protecting group, R₆ is a C-1 to C-8 alkyl, and Rₑ₁ and Rₑ₂ are individually selected from H, a C-1 to C-8 alkyl, and a C-1 to C-8 alkoxy, and "*" designates the attachment point of this end group to said polymer of structure (A), and
wherein R₄ is either selected from the group consisting of H, a C-1 to C-8 alkyl, C-1 to C-8 alkylcarbonyl (alkyl-C(=O)-), a C-1 to C-8 trialkylsilyl ((alkyl)₃Si), a C-1 to C-8 dialkylsilyl ((alkyl)₂HSi), a C-1 to C-8 monoalkylsilyl- ((alkyl)H₂Si-), silane (-H₃Si-), and a benzylic moiety, or is a moiety of structure (IV), wherein L₂ is a C-2 to C-8 alkylene, and R₇ is H, an acetal protecting group, or a trialkylsilyl protecting group, R₈ is selected from the group consisting of H, a C-1 to C-8 alkyl, C-1 to C-8 alkylcarbonyl (alkyl-C(=O)-), a C-1 to C-8 trialkylsilyl ((alkyl)₃Si), a C-1 to C-8 dialkylsilyl ((alkyl)₂HSi), a C-1 to C-8 monoalkylsilyl- ((alkyl)H₂Si-), silane (-H₃Si-), and a benzylic moiety and Rₑ₃ is selected from H, a C-1 to C-8 alkyl, and a C-1 to C-8 alkoxy, and "*" designates the attachment point of the end group to said polymer of structure (A), and further, wherein
both R₃ and R₄ cannot, simultaneously, be respectively selected from a moiety of structure (III), and a moiety of structure (IV), and
either R₃ is a moiety of structure (III) or R₄ is a moiety of structure (IV):

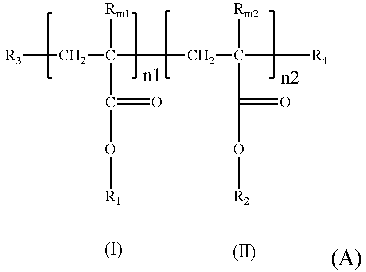

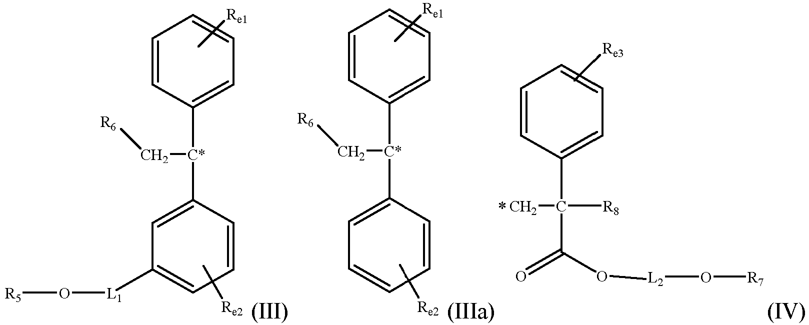

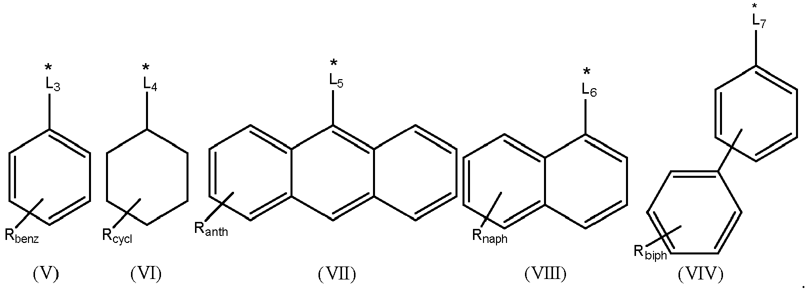

2. The polymer of claim 1, wherein said polymer has structure (A-1), wherein R₄ is selected from the group consisting of H, a C-1 to C-8 alkyl, C-1 to C-8 alkylcarbonyl (alkyl-C(=O)-), a C-1 to C-8 trialkylsilyl ((alkyl)₃Si), a C-1 to C-8 dialkylsilyl ((alkyl)₂HSi), a C-1 to C-8 monoalkylsilyl-((alkyl)H₂Si-), silane (-H₃Si-), and a benzylic moiety: 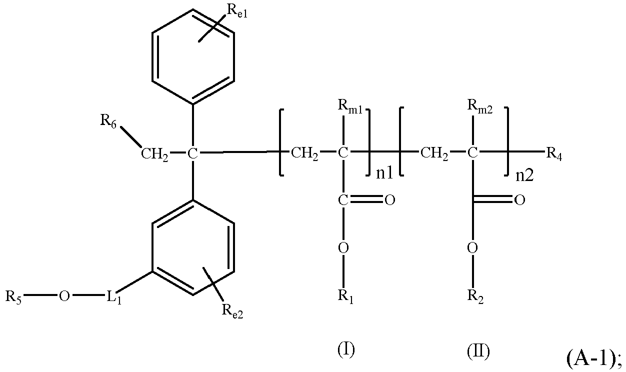 or
wherein said polymer has structure (A-2), wherein R₈ is selected from the group consisting of H, a C-1 to C-8 alkyl, C-1 to C-8 alkylcarbonyl (alkyl-C(=O)-), a C-1 to C-8 trialkylsilyl ((alkyl)₃Si), a C-1 to C-8 dialkylsilyl ((alkyl)₂HSi), a C-1 to C-8 monoalkylsilyl- ((alkyl)H₂Si-), silane (-H₃Si-), and a benzylic moiety:

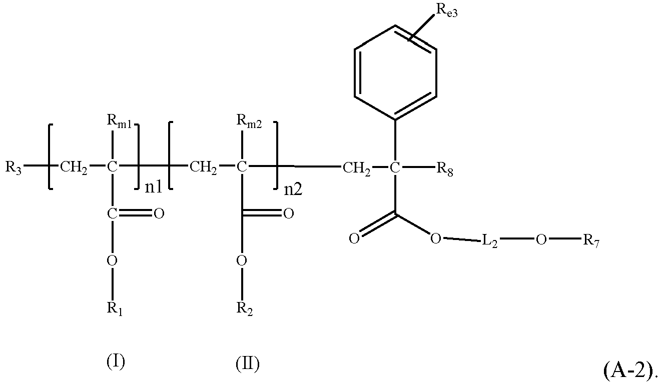

3. The polymer of claim 1 or 2, wherein said repeat unit of structure (I) is 100 mole % of the repeat units and said repeat unit of structure (II) is 0 mole %.

4. The polymer of claim 1 or 2, wherein said repeat unit of structure (II) is present.

5. The polymer of any one of claims 1 to 4, wherein R₃ has structure (III) and L₁ is a C-1 to C-2 alkylene, or wherein R₄ has structure (IV) and L₂ is a C-2 to C-4 alkylene.

6. The polymer of any one of claims 1, 2, 4 or 5, wherein said polymer has a structure selected from structure (A-3), structure (A-4), structure (A-5), structure (A-9), structure (A-10) and structure (A-11):

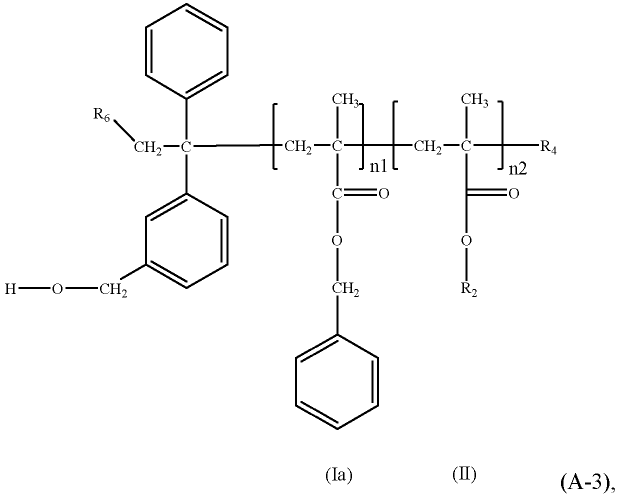

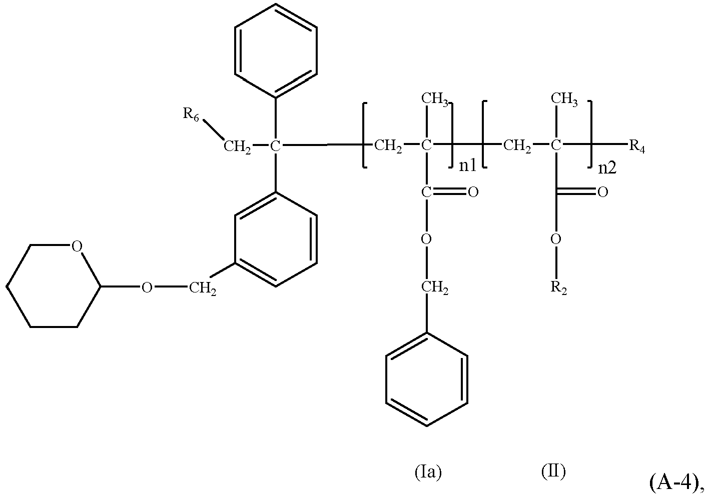

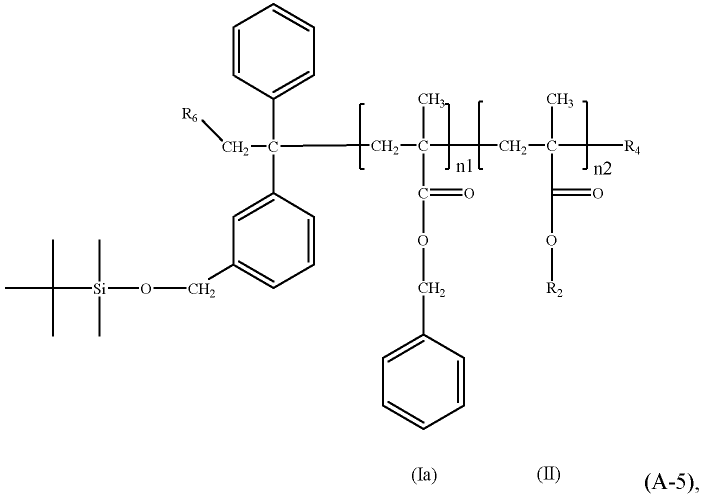

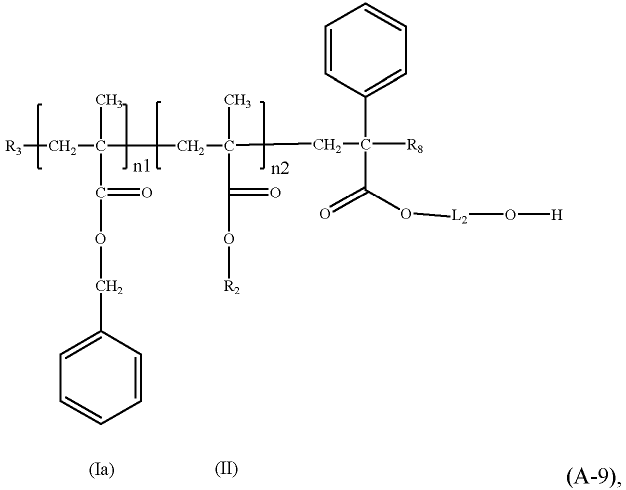

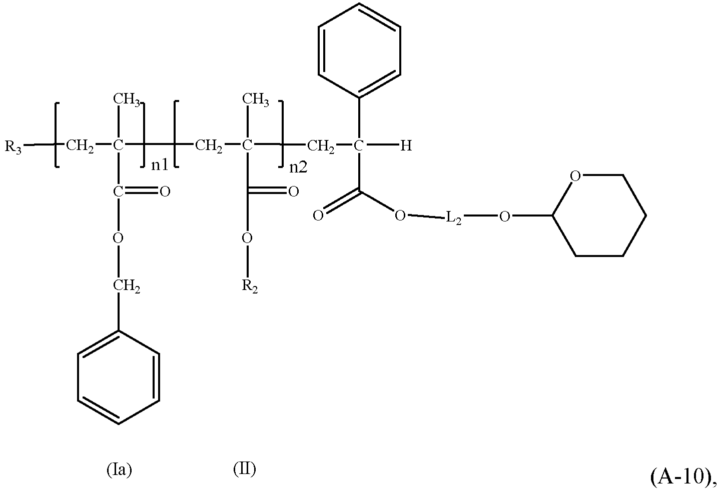

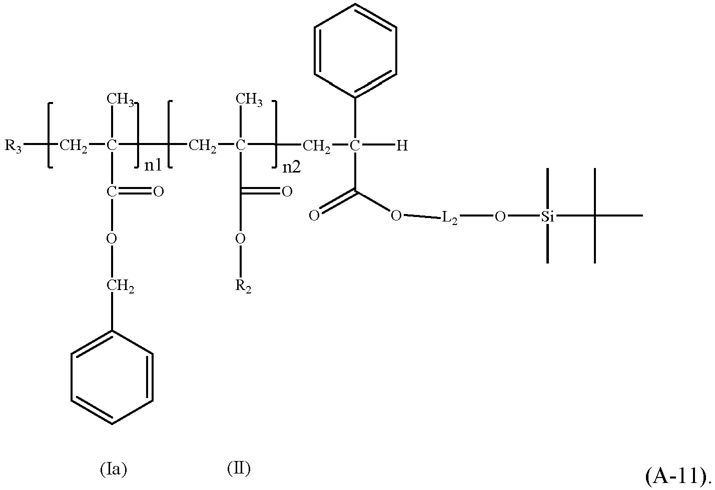

7. The polymer of any one of claims 1 to 3 or 5, wherein said polymer has a structure selected from structure (A-6), structure (A-7), structure (A-8), structure (A-12), structure (A-13) and structure (A-14):

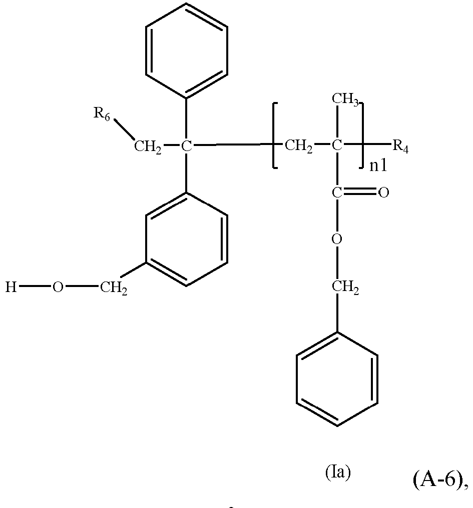

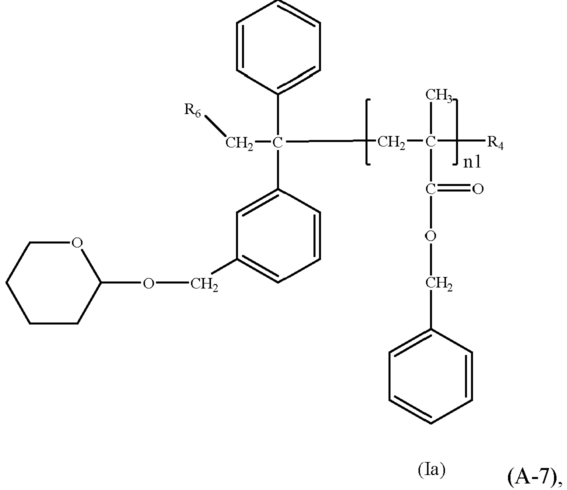

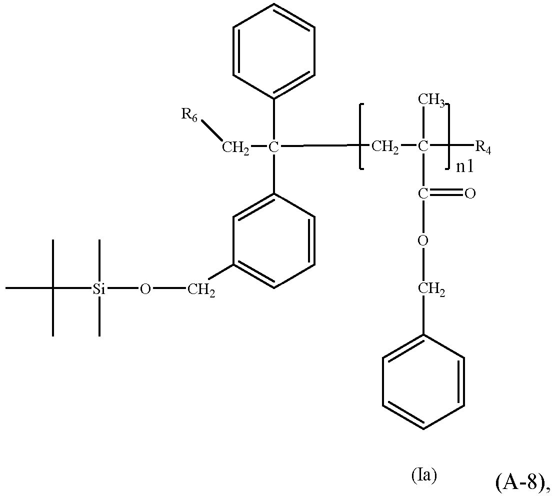

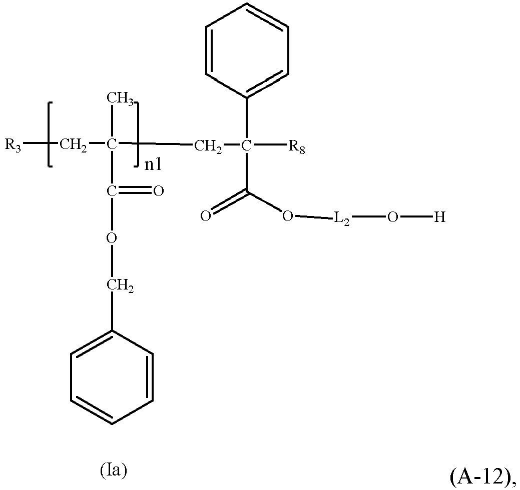

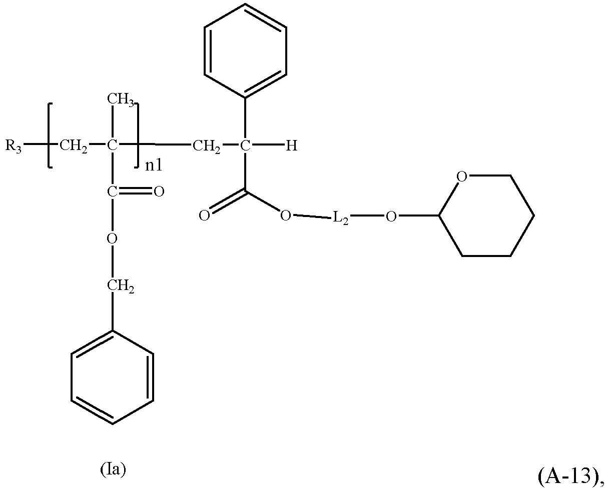

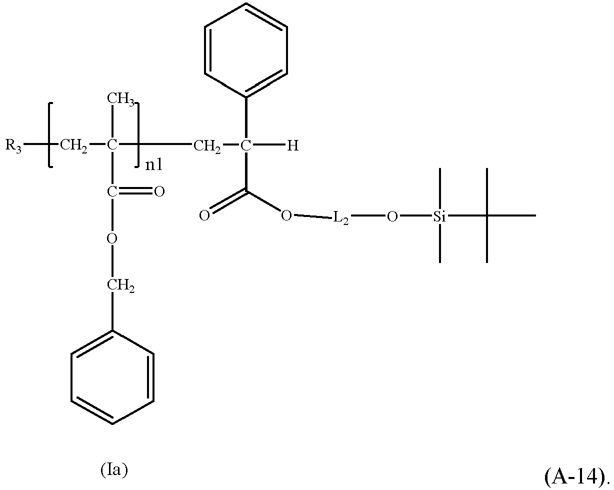

8. The polymer of any one of claims 1 to 7, which comprises both repeat units of structures (I) and (II), wherein said repeat unit of structure (II) ranges from about 1 mole % to about 60 mole % of the total repeat units of structure (I) and (II).

9. The polymer of claim 8, wherein said repeat unit of structure (I) has the more specific structure (Ia),

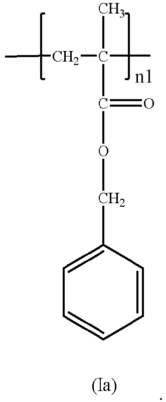

10. The polymer of claim 8 or 9, wherein said repeat unit of structure (II) has a structure selected from the more specific structure (IIa), the more specific structure (IIb), the more specific structure (IIc), and the more specific structure (IId)

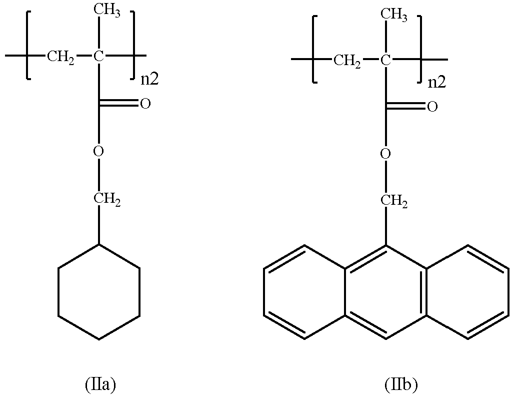

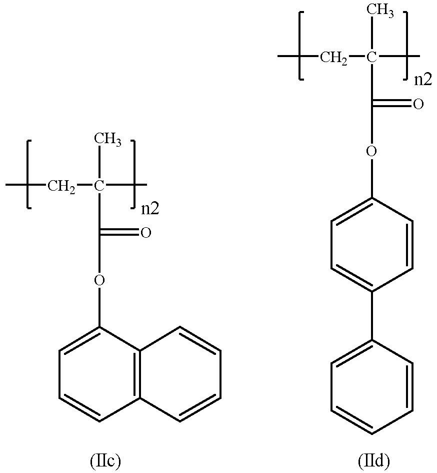

11. A composition comprising:
a polymer of any one of claims 1 to 10, and an organic spin casting solvent, wherein said polymer is one wherein either end group (III) is present and R₅ is H or end group (IV) is present and R₇ is H.

12. A process for forming a grafted coating of a polymer on a substrate comprising the steps:
i) forming a coating of a composition of claim 11 on a substrate,
ii) heating the coating at a temperature from about 90°C to about 180°C to remove solvent and to form a grafted coating of the polymer,
iii) heating the grafted coating of step ii) from about 200°C to about 250°C to form a fully cross-linked or fully crosslinked and grafted polymer coating.

13. A process for forming a grafted neutral layer coating on a substrate comprising the steps:
ia) forming a coating of a composition of claim 11 on a substrate,
iia) heating the coating at a temperature from about 90°C to about 180°C to remove solvent and to form a grafted coating,
iiia) heating the grafted coating of step iia) at a temperature from about 200°C to about 250°C to form a fully grafted neutral layer coating.

14. A process for forming a self-assembled block copolymer coating on a neutral layer coating comprising the steps:
ij) forming neutral layer coating according to claim 13,
iij) applying a block copolymer over the neutral layer coating and annealing until directed self-assembly of the block copolymer coating occurs.

15. A process of graphoepitaxy, directed self-assembly of a block copolymer coating used to form an image comprising the steps:
ik) forming neutral layer coating according to claim 13,
iik) providing a coating of a photoresist coating over the neutral layer coating,
forming a pattern in the photoresist coating,
iiik) applying a block copolymer comprising an etch resistant block and a highly etchable block over the photoresist pattern and annealing until directed self-assembly occurs; and,
ivk) etching the block copolymer, thereby removing the highly etchable block of the copolymer overcoating areas of the substrate and simultaneously forming a pattern in the substrate selectively in these areas.

16. A process of chemoepitaxy, directed self-assembly of a block copolymer coating used to form an image comprising the steps:
il) forming neutral layer coating on as substrate according claim 13,
iil) providing a coating of a photoresist coating over the neutral layer coating,
forming a pattern in the photoresist coating, thereby forming regions in which the neutral layer coating is uncovered by the resist,
iiil) treating the uncovered neutral layer coating to remove it, forming a pinning area,
ivl) removing the photoresist, uncovering the unaffected neutral layer coating forming a chemoepitaxy pattern containing neutral and pinning areas,
vl) applying a block copolymer comprising an etch resistant block and a highly etchable block over the neutral layer coating and annealing until directed self-assembly occurs; and,
vil) etching the block copolymer, thereby removing the highly etchable block of the copolymer overcoating areas of the substrate and simultaneously forming a pattern in the substrate selectively in these areas.

17. The use of the polymer according to any one of claims 1 to 10 or of the composition according to claim 11 in a process for preparing a grafted coating or a self-assembled coating on a substrate.

## Patentansprüche

1. Statistisches Polymer der Struktur (A), umfassend
eine Wiederholungseinheit der Struktur (I), wobei Rₘ₁ ein C-1- bis C-8-Alkyl ist, R₁ eine benzylische Einheit der Struktur (V) ist, wobei R_{benz} ein Substituent ist, unabhängig ausgewählt aus H, einem C-1-bis C-4-Alkyl und einem C-1- bis C-4-Alkoxy, L₃ ein C-1- bis C-4-Alkylen ist und "*" den Bindungspunkt dieses Substituenten an diese Wiederholungseinheit bezeichnet, und n1 die Anzahl dieser Wiederholungseinheit in dem Polymer bezeichnet, und ferner, wobei die Mol-% dieser Wiederholungseinheit etwa 40 Mol-% bis etwa 100 Mol-% betragen,
eine Wiederholungseinheit der Struktur (II), wobei Rₘ₂ ein C-1- bis C-8-Alkyl ist, R₂ eine Einheit ist, ausgewählt aus einem linearen C-1- bis C-20-Alkyl, einem verzweigten C-3- bis C-20-Alkyl und einem cyclischen C-5- bis C-20-Alkyl, einer Cyclohexylalkyleneinheit der Struktur (VI), einer Anthracenylalkyleneinheit der Struktur (VII), einer Naphthalenylalkyleneinheit der Struktur (VIII) und einer Biphenyleinheit der Struktur (VIV), wobei L₄ und L₅ unabhängig ausgewählt sind aus einer C-1-bis C-4-Alkyleneinheit, L₆ und L₇ unabhängig ausgewählt sind aus einer direkten Valenzbindung oder einer C-1- bis C-4-Alkyleneinheit, R_{cycl}, Rₐₙₜₕ, Rₙₐₚₕ, R_{biph} Substituenten sind, unabhängig ausgewählt aus H, einem C-1- bis C-4-Alkyl und einem C-1- bis C-4-Alkoxy, n2 die Anzahl dieser Wiederholungseinheit im Polymer bezeichnet, und wobei ferner die Mol-% dieser Wiederholungseinheit etwa 0 Mol-% bis etwa 60 Mol-% betragen, und wobei ferner die gesamten Mol-% der Wiederholungseinheiten in dem Polymer aus Wiederholungseinheiten der Strukturen (I) und (II) 100 Mol-% betragen;
zwei Endgruppen R₃ und R₄, wobei
Endgruppe R₃, die von einem anionischen Initiator abgeleitet ist, wobei R₃ entweder eine Einheit der Struktur (IIIa) ist, oder eine Einheit der Struktur (III) ist, wobei L₁ ein C-1- bis C-8-Alkylen ist und R₅ H, eine Acetalschutzgruppe oder eine Trialkylsilylschutzgruppe ist, R₆ ein C-1- bis C-8-Alkyl ist und Rₑ₁ und Rₑ₂ unabhängig ausgewählt sind aus H, einem C-1- bis C-8-Alkyl und einem C-1- bis C-8-Alkoxy, und "*" den Bindungspunkt dieser Endgruppe an das Polymer der Struktur (A) bezeichnet, und wobei R₄ entweder aus der Gruppe ausgewählt ist bestehend aus H, einem C-1- bis C-8-Alkyl, C-1- bis C-8-Alkylcarbonyl (Alkyl-C(=O)-), einem C-1- bis C-8-Trialkylsilyl ((Alkyl)₃Si), C-1- bis C-8-Dialkylsilyl ((Alkyl)₂HSi), C-1- bis C-8-Monoalkylsilyl- ((Alkyl)H₂Si-), Silan (-H₃Si-) und einer benzylischen Einheit, oder eine Einheit der Struktur (IV) ist, wobei L₂ ein C-2- bis C-8-Alkylen ist und R₇ H, eine Acetalschutzgruppe oder eine Trialkylsilylschutzgruppe ist, R₈ aus der Gruppe ausgewählt ist bestehend aus H, einem C-1- bis C-8-Alkyl, einem C-1- bis C-8-Alkylcarbonyl (Alkyl-C(=O)-), einem C-1- bis C-8-Trialkylsilyl ((Alkyl)₃Si), einem C-1- bis C-8-Dialkylsilyl ((alkyl)₂HSi), einem C-1- bis C-8-Monoalkylsilyl ((alkyl)H₂Si-), Silan (-H₃Si-) und einer benzylischen Einheit und Rₑ₃ ausgewählt ist aus H, einem C-1 bis C-8-Alkyl und einem C-1 bis C-8-Alkoxy, und "*" den Bindungspunkt der Endgruppe an das Polymer der Struktur (A) bezeichnet, und ferner, wobei
sowohl R₃ als auch R₄ nicht gleichzeitig aus einer Einheit der Struktur (III) bzw. einer Einheit der Struktur (IV) ausgewählt sein können und
entweder R₃ eine Einheit der Struktur (III) ist oder R₄ eine Einheit der Struktur (IV) ist:

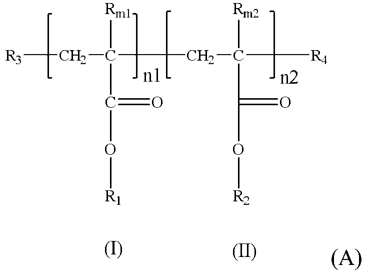

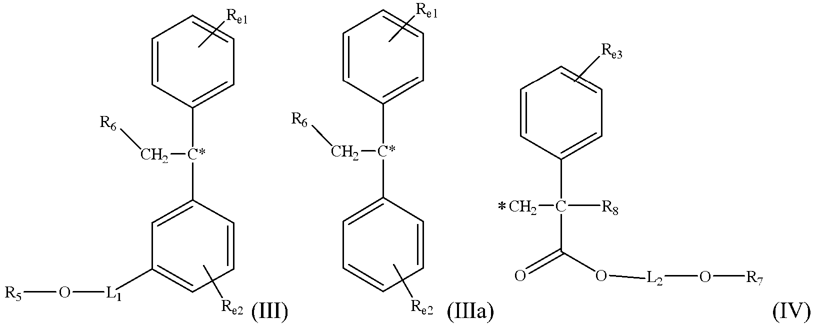

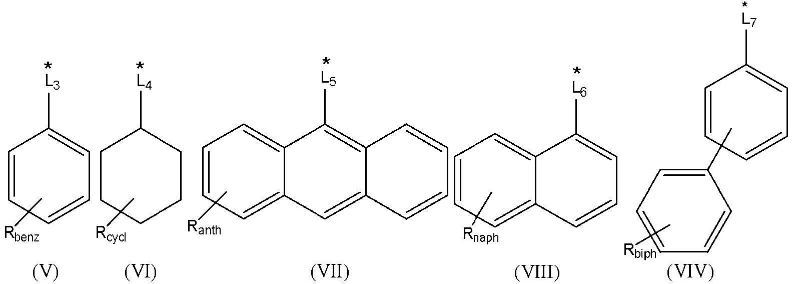

2. Polymer nach Anspruch 1, wobei das Polymer die Struktur (A-1) aufweist, wobei R₄ ausgewählt ist aus der Gruppe bestehend aus H, einem C-1- bis C-8-Alkyl, C-1- bis C-8-Alkylcarbonyl (Alkyl-C(=O)-), einem C-1- bis C-8-Trialkylsilyl ((Alkyl)₃Si), C-1- bis C-8-Dialkylsilyl ((Alkyl)₂HSi), C-1- bis C-8-Monoalkylsilyl- ((Alkyl)H₂Si-), Silan (-H₃Si-) und einer benzylischen Einheit: 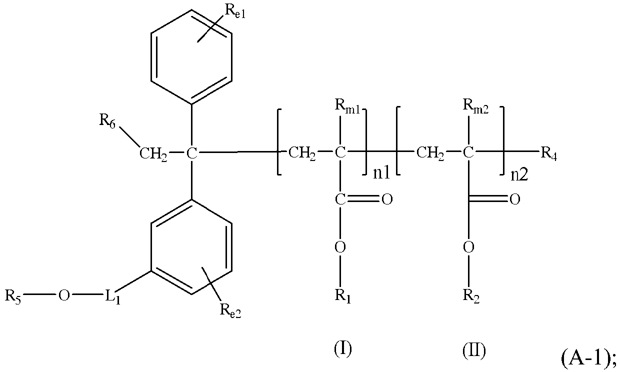 oder
wobei das Polymer die Struktur (A-2) aufweist, wobei R₈ ausgewählt ist aus der Gruppe bestehend aus H, einem C-1- bis C-8-Alkyl, C-1- bis C-8-Alkylcarbonyl (Alkyl-C(=O)-), einem C-1- bis C-8-Trialkylsilyl ((Alkyl)₃Si), C-1- bis C-8-Dialkylsilyl ((alkyl)₂HSi), C-1- bis C-8-Monoalkylsilyl ((alkyl)H₂Si-), Silan (-H₃Si-) und einer benzylischen Einheit:

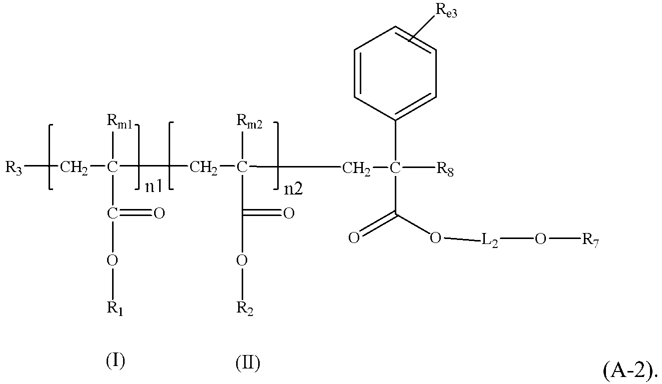

3. Polymer nach Anspruch 1 oder 2, wobei die Wiederholungseinheit der Struktur (I) 100 Mol-% der Wiederholungseinheiten ausmacht und die Wiederholungseinheit der Struktur (II) 0 Mol-% ausmacht.

4. Polymer nach Anspruch 1 oder 2, wobei die Wiederholungseinheit der Struktur (II) vorhanden ist.

5. Polymer nach einem der Ansprüche 1 bis 4, wobei R₃ die Struktur (III) aufweist und L₁ ein C-1- bis C-2-Alkylen ist, oder wobei R₄ die Struktur (IV) aufweist und L₂ ein C-2- bis C-4-Alkylen ist.

6. Polymer nach einem der Ansprüche 1, 2, 4 oder 5, wobei das Polymer eine Struktur aufweist, ausgewählt aus Struktur (A-3), Struktur (A-4), Struktur (A-5), Struktur (A-9), Struktur (A-10) und Struktur (A-11):

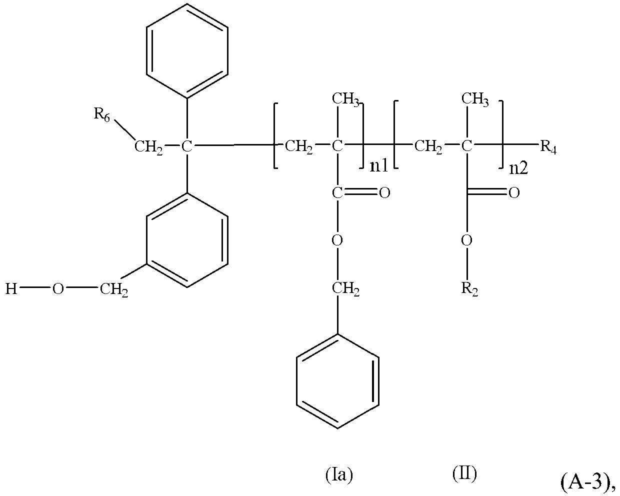

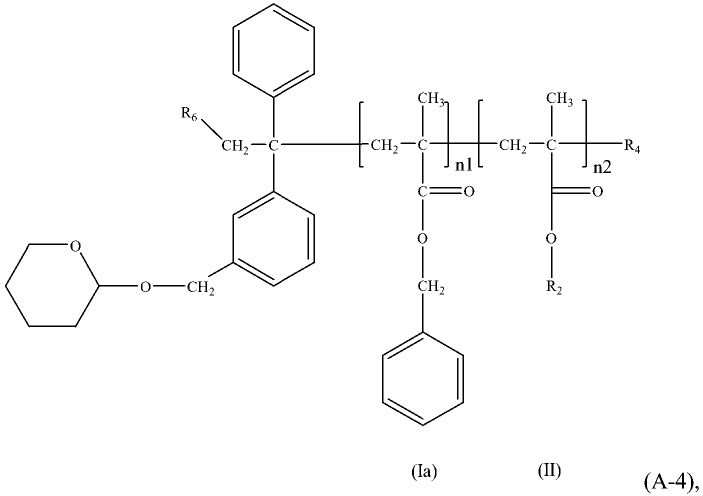

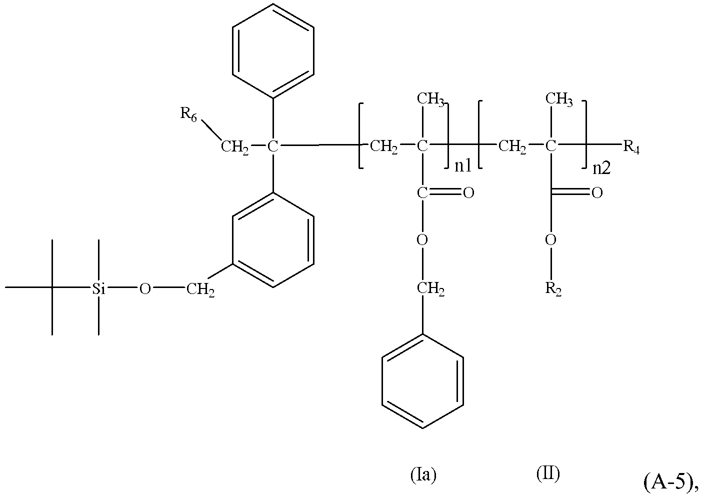

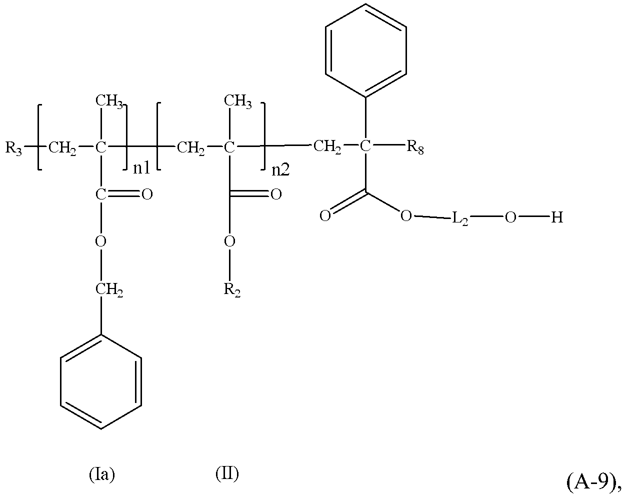

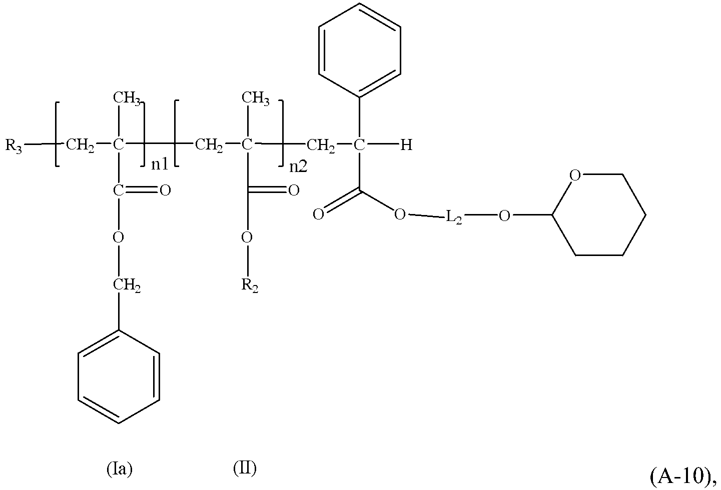

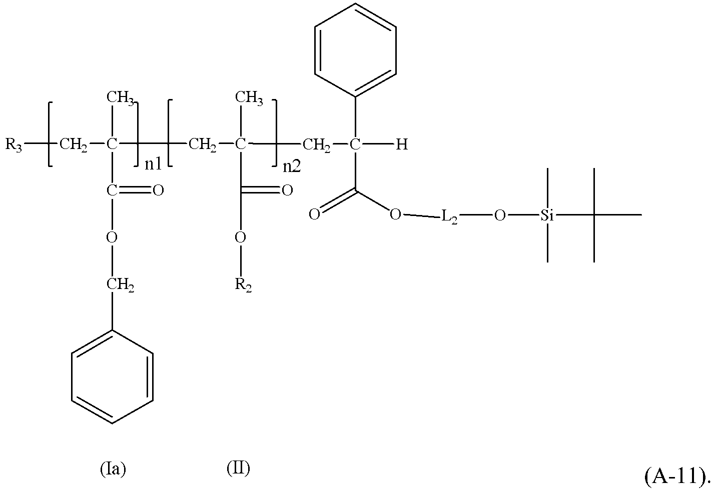

7. Polymer nach einem der Ansprüche 1 bis 3 oder 5, wobei das Polymer eine Struktur aufweist, ausgewählt aus Struktur (A-6), Struktur (A-7), Struktur (A-8), Struktur (A-12), Struktur (A-13) und Struktur (A-14):

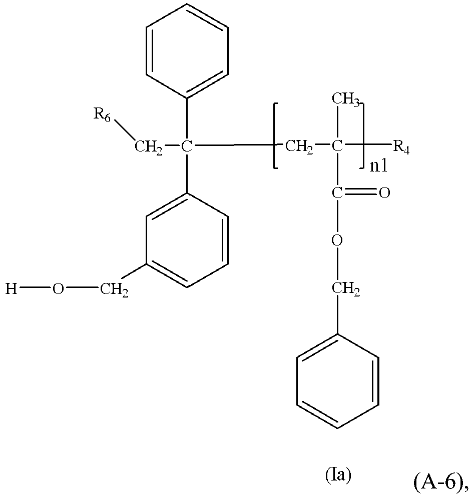

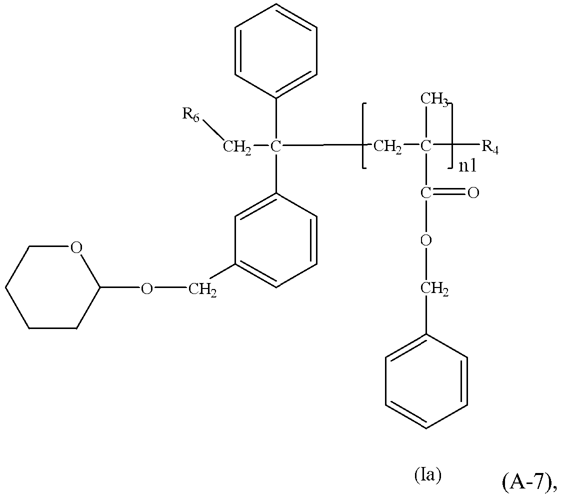

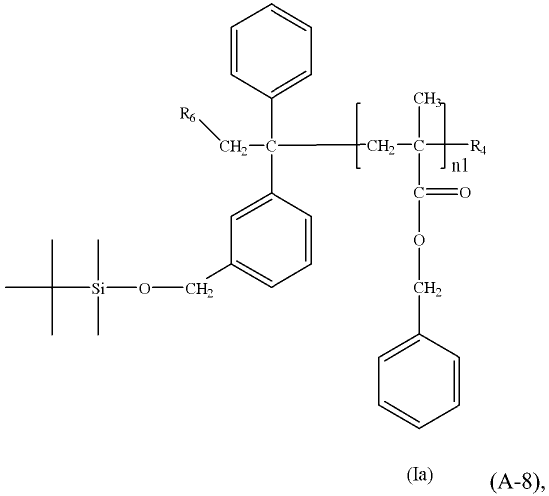

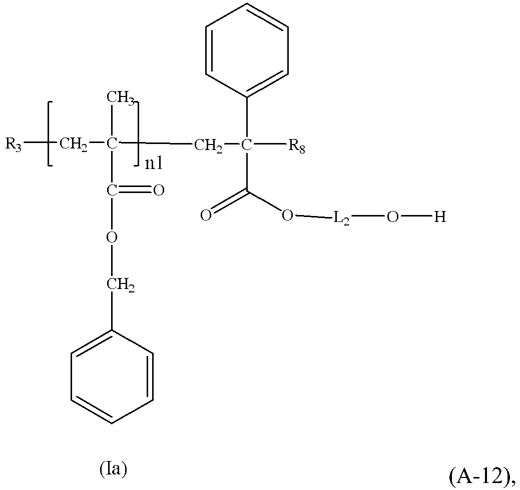

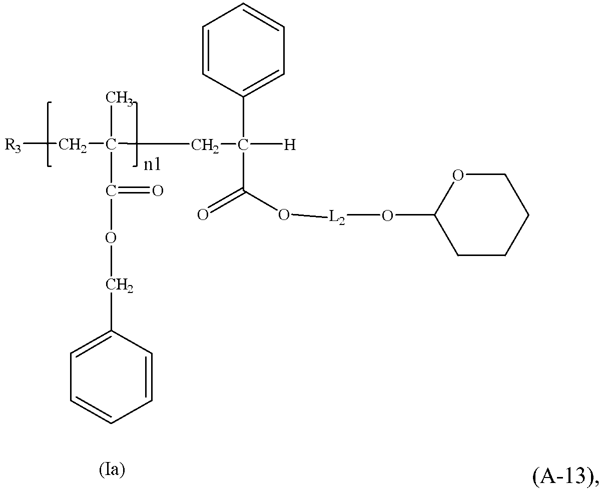

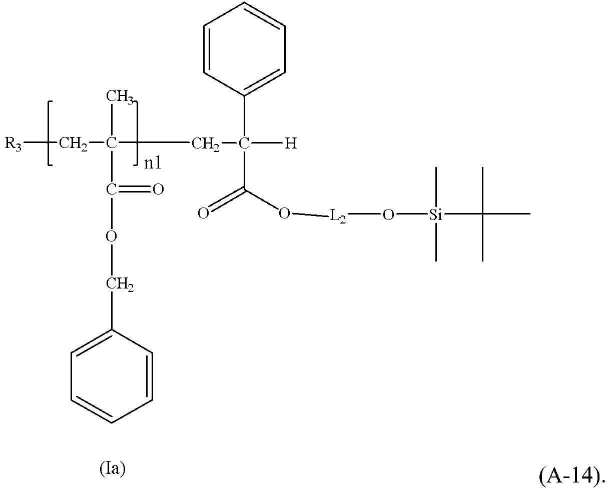

8. Polymer nach einem der Ansprüche 1 bis 7, das sowohl Wiederholungseinheiten der Strukturen (I) als auch (II) umfasst, wobei die Wiederholungseinheit der Struktur (II) von etwa 1 Mol-% bis etwa 60 Mol-% der gesamten Wiederholungseinheiten der Strukturen (I) und (II) reicht.

9. Polymer nach Anspruch 8, wobei die Wiederholungseinheit der Struktur (I) die spezifischere Struktur (Ia) aufweist,

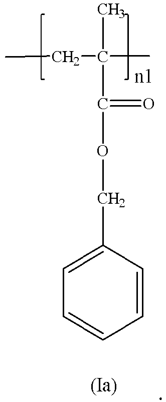

10. Polymer nach Anspruch 8 oder 9, wobei die Wiederholungseinheit der Struktur (II) eine Struktur aufweist, ausgewählt aus der spezifischeren Struktur (IIa), der spezifischeren Struktur (IIb), der spezifischeren Struktur (IIc) und der spezifischeren Struktur (IId)

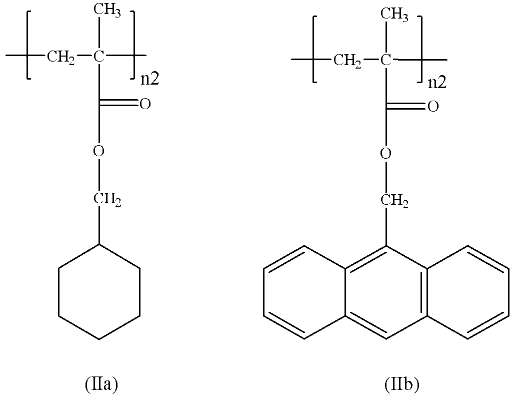

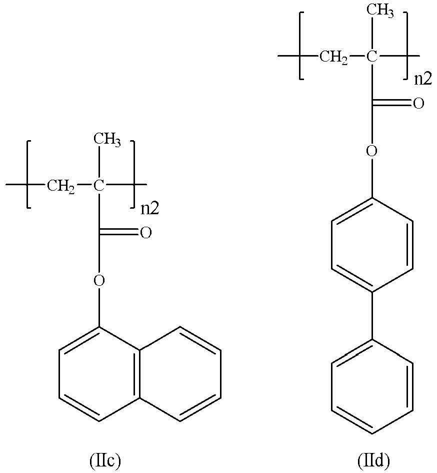

11. Zusammensetzung, umfassend:
ein Polymer nach einem der Ansprüche 1 bis 10 und ein organisches Schleuderguss-Lösungsmittel, wobei das Polymer eines ist, bei dem entweder die Endgruppe (III) vorhanden ist und R₅ H ist oder die Endgruppe (IV) vorhanden ist und R₇ H ist.

12. Verfahren zur Bildung einer gepfropften Beschichtung aus einem Polymer auf einem Substrat, umfassend die Schritte:
i) Bilden einer Beschichtung aus einer Zusammensetzung nach Anspruch 11 auf einem Substrat,
ii) Erhitzen der Beschichtung auf eine Temperatur von etwa 90 °C bis etwa 180 °C, um das Lösungsmittel zu entfernen und eine gepfropfte Beschichtung des Polymers zu bilden,
iii) Erhitzen der gepfropften Beschichtung aus Schritt ii) auf etwa 200 °C bis etwa 250 °C, um eine vollständig vernetzte oder vollständig vernetzte und gepfropfte Polymerbeschichtung zu bilden.

13. Verfahren zur Bildung einer gepfropften Neutralschicht-Beschichtung auf einem Substrat, umfassend die Schritte:
ia) Bilden einer Beschichtung aus einer Zusammensetzung gemäß Anspruch 11 auf einem Substrat,
iia) Erhitzen der Beschichtung auf eine Temperatur von etwa 90 °C bis etwa 180 °C, um Lösungsmittel zu entfernen und eine gepfropfte Beschichtung zu bilden,
iiia) Erhitzen der gepfropften Beschichtung aus Schritt iia) auf eine Temperatur von etwa 200 °C bis etwa 250 °C, um eine vollständig gepfropfte Neutralschicht-Beschichtung zu bilden.

14. Verfahren zum Bilden einer selbstangeordneten Blockcopolymerbeschichtung auf einer Neutralschicht-Beschichtung, umfassend die Schritte:
ij) Bilden einer Neutralschicht-Beschichtung gemäß Anspruch 13,
iij) Aufbringen eines Blockcopolymers über die Neutralschicht-Beschichtung und Tempern, bis eine gerichtete Selbstanordnung der Blockcopolymerbeschichtung auftritt.

15. Verfahren zur Graphoepitaxie, gerichteter Selbstanordnung einer Blockcopolymerbeschichtung, die zum Bilden einer Abbildung verwendet wird, umfassend die Schritte:
ik) Bilden einer Neutralschicht-Beschichtung gemäß Anspruch 13,
iik) Bereitstellen einer Beschichtung aus einer Fotolackbeschichtung über der Neutralschicht-Beschichtung,
Bilden eines Musters in der Fotolackbeschichtung,
iiik) Aufbringen eines Blockcopolymers umfassend einen ätzbeständigen Block und einen hochätzbaren Block über das Fotolackmuster und Tempern, bis gerichtete Selbstanordnung auftritt; und
ivk) Ätzen des Blockcopolymers, wodurch der stark ätzbare Block des Copolymers, der Bereiche des des Substrats überschichtet, entfernt wird, und gleichzeitig Bilden eines Musters in dem Substrat selektiv in diesen Bereichen.

16. Verfahren zur Chemoepitaxie, gerichteter Selbstanordnung einer Blockcopolymerbeschichtung, die zum Bilden einer Abbildung verwendet wird, umfassend die Schritte:
il) Bilden einer Neutralschicht-Beschichtung auf einem Substrat gemäß Anspruch 13,
iil) Bereitstellen einer Beschichtung aus einer Fotolackbeschichtung über der Neutralschicht-Beschichtung,
Bilden eines Musters in der Fotolackbeschichtung, wodurch Bereiche gebildet werden, in denen die Neutralschicht-Beschichtung durch den Lack freigelegt ist,
iiil) Behandeln der freigelegten Neutralschicht-Beschichtung, um sie zu entfernen, einen Pinning-Bereich bildend,
ivl) Entfernen des Fotolacks, die nicht betroffene Neutralschicht-Beschichtung freilegend, wodurch ein Chemoepitaxie-Muster umfassend neutrale Bereiche und Pinning-Bereiche gebildet wird,
vl) Aufbringen eines Blockcopolymers, umfassend einen ätzbeständigen Block und einen hochätzbaren Block, über die Neutralschicht-Beschichtung und Tempern, bis gerichtete Selbstanordnung auftritt; und
vil) Ätzen des Blockcopolymers, wodurch der stark ätzbare Block des Copolymers, der Bereiche des des Substrats überschichtet, entfernt wird und gleichzeitig Bilden eines Musters in dem Substrat selektiv in diesen Bereichen.

17. Verwendung des Polymers gemäß einem der Ansprüche 1 bis 10 oder der Zusammensetzung gemäß Anspruch 11 in einem Verfahren zur Herstellung einer gepfropften Beschichtung oder einer selbstangeordneten Beschichtung auf einem Substrat.

## Revendications

1. Polymère statistique de structure (A), comprenant
un motif répétitif de structure (I), Rₘ₁ étant un C-1 à C-8 alkyle, R₁ étant un groupement comprenant benzylique de structure (V), R_{benz} étant un substituant individuellement choisi parmi H, un C-1 à C-4 alkyle, et un C-1 à C-4 alcoxy, L₃ étant un C-1 à C-4 alkylène, et « * » désignant le point de fixation de ce substituant au motif répétitif, et n1 désignant le nombre de ce motif répétitif dans le polymère, et en outre le % en moles de ce motif répétitif étant d'environ 40 % en moles à environ 100 % en moles,
un motif répétitif de structure (II), Rₘ₂ étant un C-1 à C-8 alkyle, R₂ étant un groupement choisi parmi un C-1 à C-20 alkyle linéaire, un C-3 à C-20 alkyle ramifié, et un C-5 à C-20 alkyle cyclique, un groupement cyclohexylalkylène de structure (VI), un groupement anthracénylalkylène de structure (VII), un groupement naphtalénylalkylène de structure (VIII), et un groupement biphényle de structure (VIV), L₄ et L₅ étant indépendamment choisis parmi un C-1 à C-4 alkylène, L₆ et L₇ étant indépendamment choisis parmi une liaison de valence directe ou un groupement C-1 à C-4 alkylène, R_{cycl}, Rₐₙₜₕ, Rₙₐₚₕ, R_{biph}, étant des substituants individuellement choisis parmi H, un C-1 à C-4 alkyle, et un C-1 à C-4 alcoxy, n2 désignant le nombre de ce motif répétitif dans le polymère, et en outre le % en moles de ce motif répétitif étant d'environ 0 % en moles à environ 60 % en moles, et en outre le % en moles total des motifs répétitifs dans ledit polymère de motifs répétitifs de structures (I) et (II) étant 100 % en moles ;
deux groupes terminaux R₃ et R₄
un groupe terminal R₃, qui est dérivé d'un initiateur anionique, R₃ étant soit un groupement de structure (IIIa), soit étant un groupement de structure (III), L₁ étant un C-1 à C-8 alkylène, et R₅ étant H, un groupe protecteur de type acétal, ou un groupe protecteur trialkylsilyle, R₆ étant un C-1 à C-8 alkyle, et Rₑ₁ et Rₑ₂ étant individuellement choisis parmi H, un C-1 à C-8 alkyle, et un C-1 à C-8 alcoxy, et « * » désignant le point de fixation de ce groupe terminal audit polymère de structure (A), et
R₄ étant soit choisi dans le groupe constitué par H, un C-1 à C-8 alkyle, C-1 à C-8 alkylcarbonyle (alkyl-C(=O)-), un C-1 à C-8 trialkylsilyle ((alkyl)₃Si), un C-1 à C-8 dialkylsilyle ((alkyl)₂HSi), un C-1 à C-8 monoalkylsilyl- ((alkyl)H₂Si-), silane (-H₃Si-), et un groupement benzylique, soit étant un groupement de structure (IV), L₂ étant un C-2 à C-8 alkylène, et R₇ étant H, un groupe protecteur de type acétal ou un groupe protecteur trialkylsilyle, R₈ étant choisi dans le groupe constitué par H, un C-1 à C-8 alkyle, C-1 à C-8 alkylcarbonyle (alkyl-C(=O)-), un C-1 à C-8 trialkylsilyle ((alkyl)₃Si), un C-1 à C-8 dialkylsilyle ((alkyl)₂HSi), un C-1 à C-8 monoalkylsilyl- ((alkyl)H₂Si-), silane (-H₃Si-), et un groupement benzylique et Rₑ₃ étant choisi parmi H, un C-1 à C-8 alkyle, et un C-1 à C-8 alcoxy, et « * » désignant le point de fixation du groupe terminal audit polymère de structure (A), et en outre,
les deux R₃ et R₄ ne pouvant pas, simultanément, être respectivement choisis parmi un groupement de structure (III), et un groupement de structure (IV), et soit R₃ est un groupement de structure (III) soit R₄ est un groupement de structure (IV) :

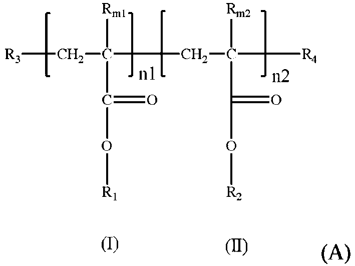

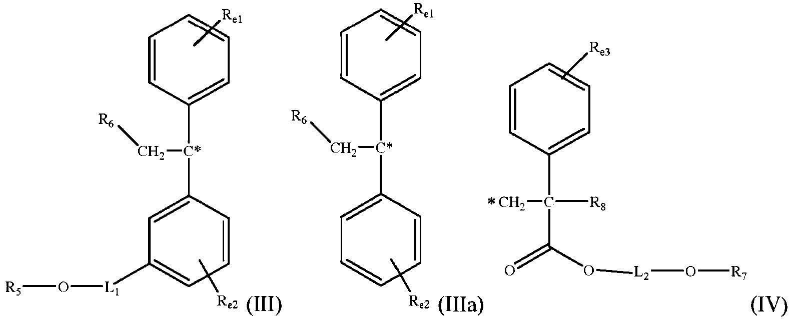

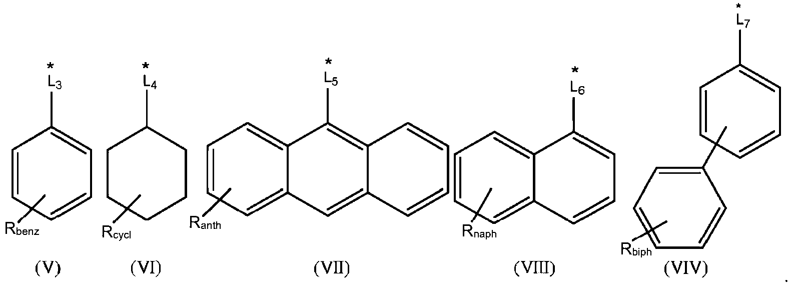

2. Polymère selon la revendication 1, ledit polymère ayant une structure (A-1), R₄ étant choisi dans le groupe constitué par H, un C-1 à C-8 alkyle, C-1 à C-8 alkylcarbonyle (alkyl-C(=O)-), un C-1 à C-8 trialkylsilyle ((alkyl)₃Si), un C-1 à C-8 dialkylsilyle ((alkyl)₂HSi), un C-1 à C-8 monoalkylsilyl- ((alkyl)H₂Si-), silane (-H₃Si-), et un groupement benzylique : 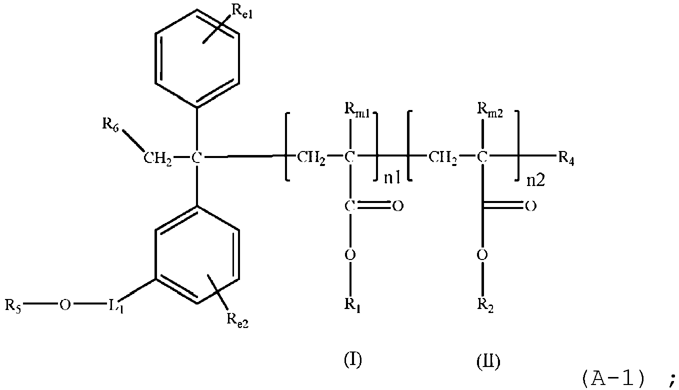 ou ledit polymère ayant la structure (A-2), R₈ étant choisi dans le groupe constitué par H, un C-1 à C-8 alkyle, C-1 à C-8 alkylcarbonyle (alkyl-C(=O)-), un C-1 à C-8 trialkylsilyle ((alkyl)₃Si), un C-1 à C-8 dialkylsilyle ((alkyl)₂HSi), un C-1 à C-8 monoalkylsilyl- ((alkyl)H₂Si-), silane (-H₃Si-), et un groupement benzylique :

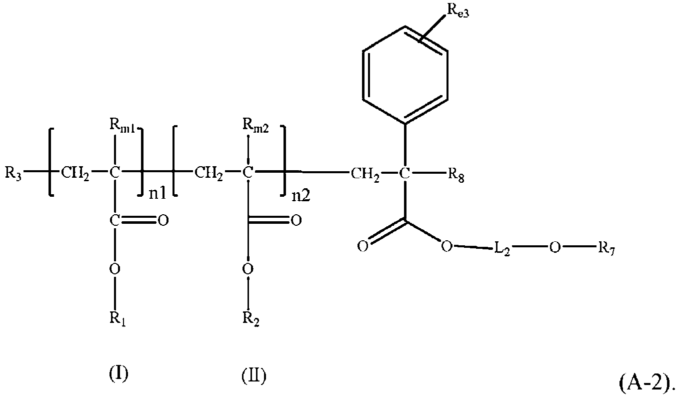

3. Polymère selon la revendication 1 ou 2, dans lequel ledit motif répétitif de structure (I) représente 100 % en moles des motifs répétitifs et ledit motif répétitif de structure (II) représente 0 % en moles.

4. Polymère selon la revendication 1 ou 2, dans lequel ledit motif répétitif de structure (II) est présent.

5. Polymère selon l'une quelconque des revendications 1 à 4, dans lequel R₃ a la structure (III) et L₁ est un alkylène en C-1 à C-2 ou dans lequel R₄ a la structure (IV) et L₂ est un alkylène en C-2 à C-4.

6. Polymère selon l'une quelconque des revendications 1, 2, 4 ou 5, dans lequel ledit polymère a une structure choisie parmi la structure (A-3), la structure (A-4), la structure (A-5), la structure (A-9), la structure (A-10) et la structure (A-11) :

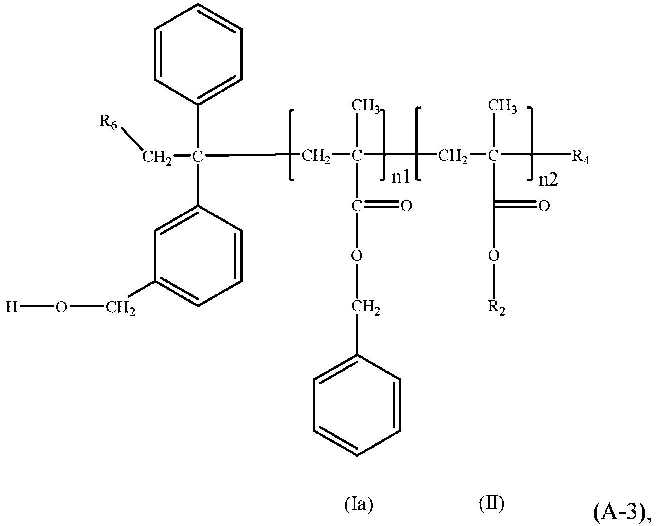

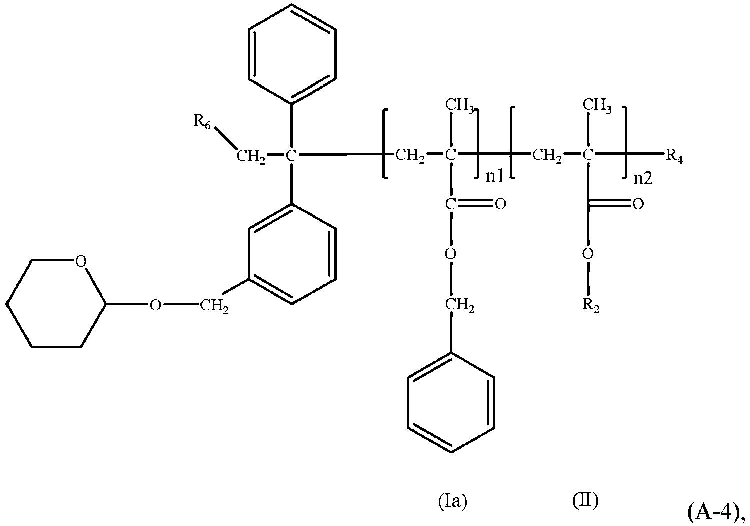

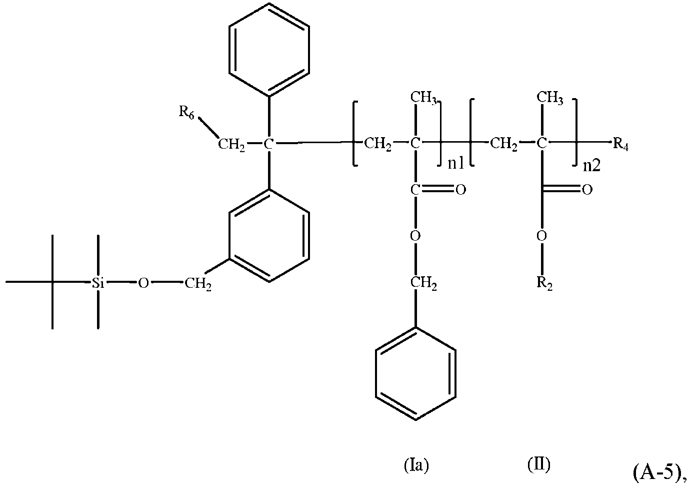

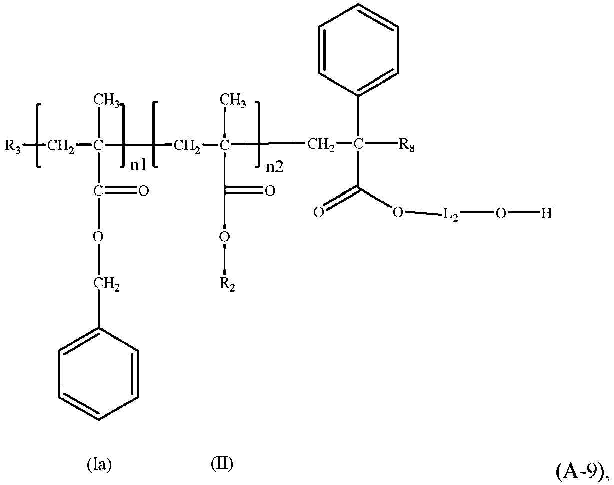

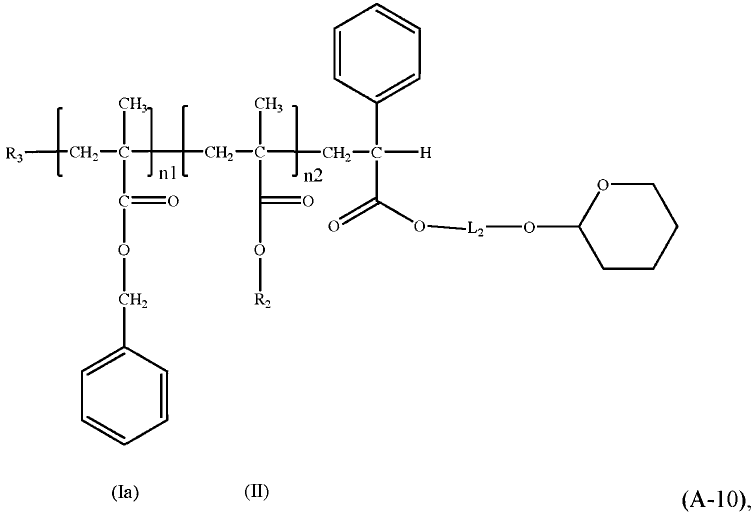

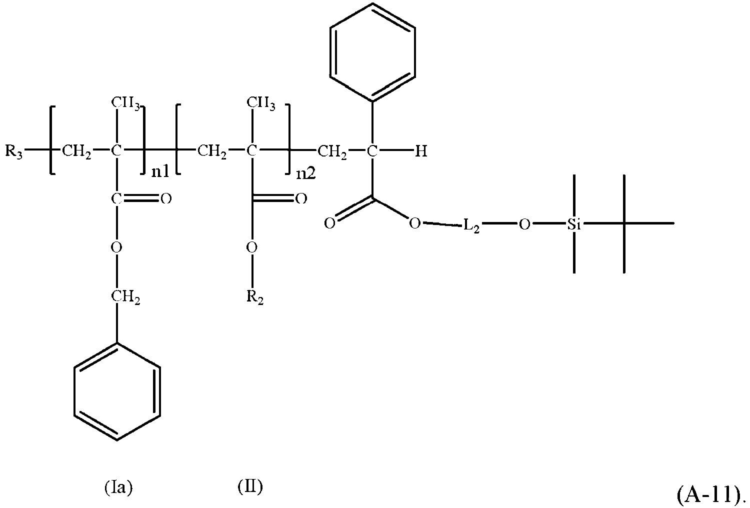

7. Polymère selon l'une quelconque des revendications 1 à 3 ou 5, dans lequel ledit polymère a une structure choisie parmi la structure (A-6), la structure (A-7), la structure (A-8), la structure (A-12), la structure (A-13) et la structure (A-14) :

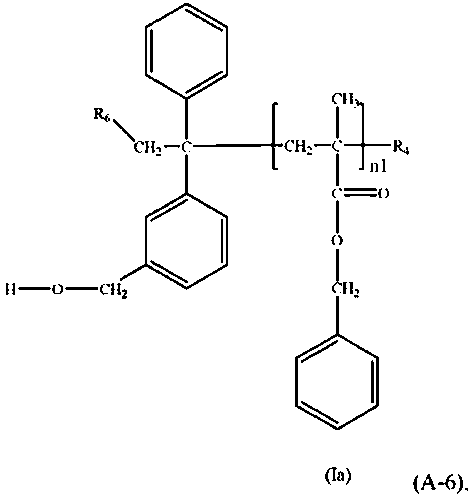

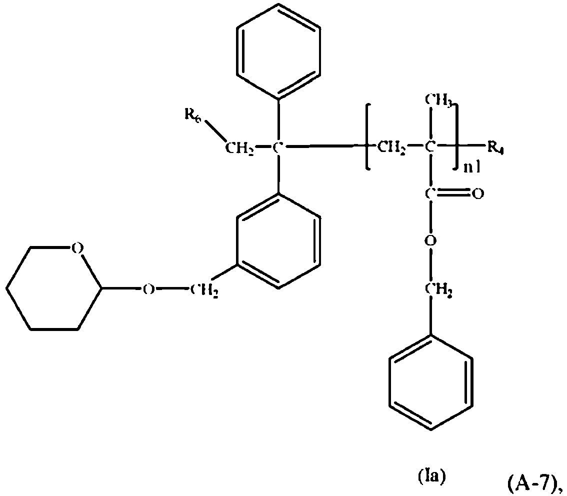

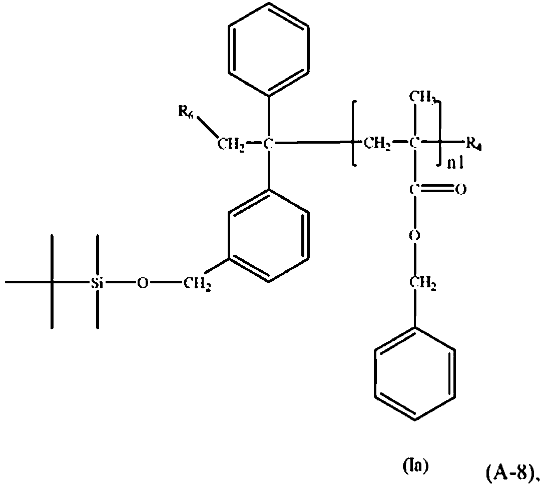

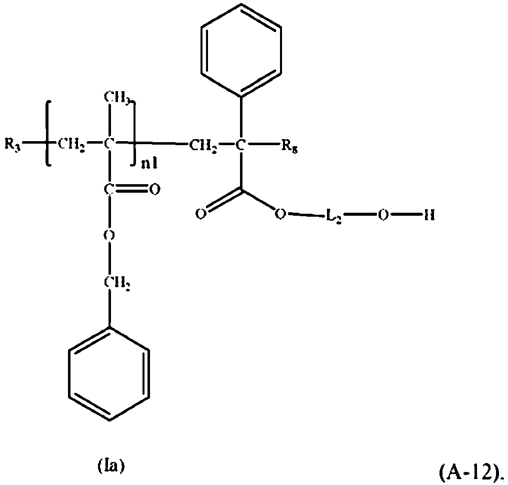

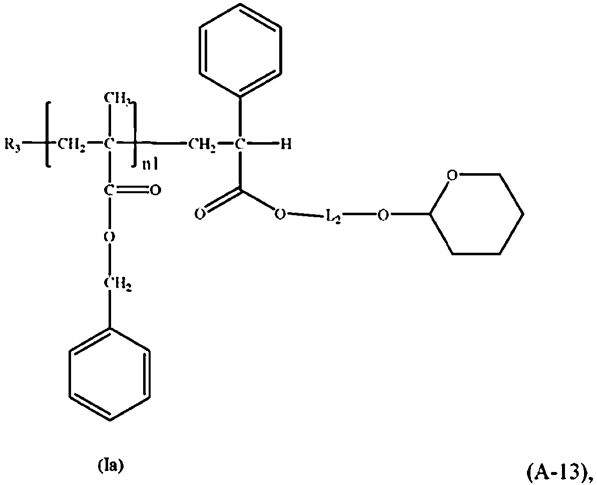

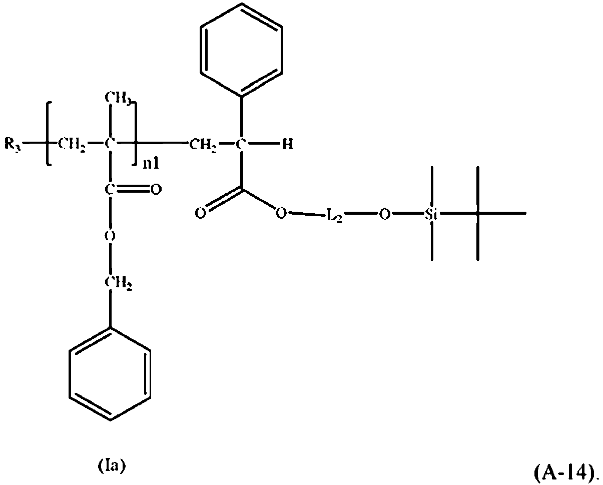

8. Polymère selon l'une quelconque des revendications 1 à 7, qui comprend à la fois des motifs répétitifs de structures (I) et (II), dans lequel ledit motif répétitif de structure (II) représente environ 1 % en moles à environ 60 % en moles du total des motifs répétitifs de structure (I) et (II).

9. Polymère selon la revendication 8, dans lequel ledit motif répétitif de structure (I) a la structure plus spécifique (Ia),

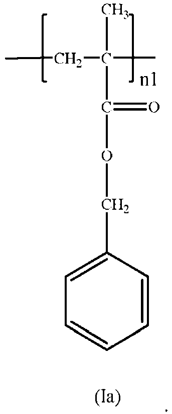

10. Polymère selon la revendication 8 ou 9, dans lequel ledit motif répétitif de structure (II) a une structure choisie parmi la structure plus spécifique (IIa), la structure plus spécifique (IIb), la structure plus spécifique (IIc) et la structure plus spécifique (IId)

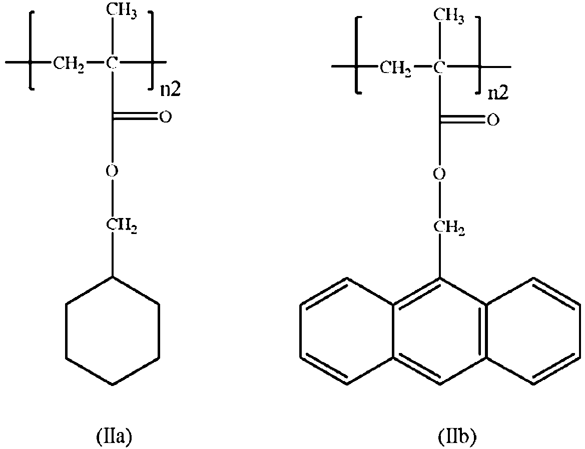

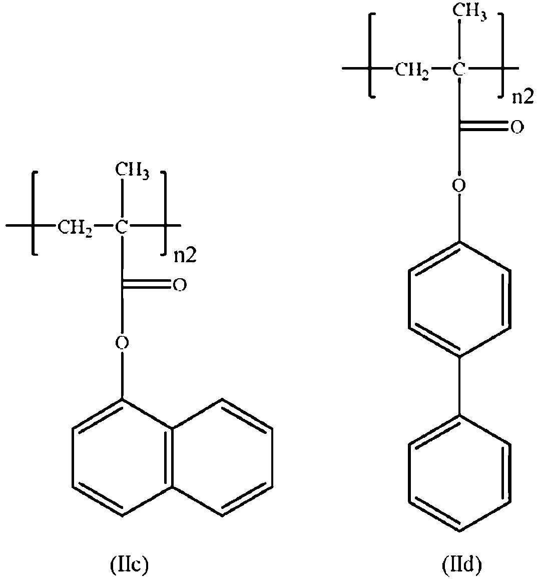

11. Composition comprenant :
un polymère selon l'une quelconque des revendications 1 à 10, et un solvant organique de coulée par centrifugation, dans lequel ledit polymère est un polymère dans lequel soit le groupe terminal (III) est présent et R₅ est H, soit le groupe terminal (IV) est présent et R₇ est H.

12. Procédé de formation d'un revêtement greffé d'un polymère sur un substrat comprenant les étapes :
i) formation d'un revêtement d'une composition selon la revendication 11 sur un substrat,
ii) chauffage du revêtement à une température d'environ 90 °C jusqu'à environ 180 °C pour éliminer le solvant et former un revêtement greffé du polymère,
iii) chauffage du revêtement greffé de l'étape ii) d'environ 200 °C jusqu'à environ 250 °C pour former un revêtement de polymère entièrement réticulé ou entièrement réticulé et greffé.

13. Procédé de formation d'un revêtement de couche neutre greffé sur un substrat comprenant les étapes :
ia) formation d'un revêtement d'une composition de la revendication 11 sur un substrat,
iia) chauffage du revêtement à une température d'environ 90 °C jusqu'à environ 180 °C pour éliminer du solvant et pour former un revêtement greffé,
iiia) chauffage du revêtement greffé de l'étape iia) à une température d'environ 200 °C jusqu'à environ 250 °C pour former un revêtement de couche neutre entièrement greffé.

14. Procédé de formation d'un revêtement de copolymère séquencé auto-assemblé sur un revêtement de couche neutre comprenant les étapes :
ij) formation d'un revêtement de couche neutre selon la revendication 13,
iij) application d'un copolymère séquencé sur le revêtement de couche neutre et recuit jusqu'à ce qu'un auto-assemblage dirigé du revêtement de copolymère séquencé se produise.

15. Procédé de graphoépitaxie, auto-assemblage dirigé d'un revêtement de copolymère séquencé utilisé pour former une image, comprenant les étapes :
ik) formation d'un revêtement de couche neutre selon la revendication 13,
iik) application d'un revêtement de photorésine sur le revêtement de couche neutre,
formation d'un motif dans le revêtement de photorésine,
iiik) application d'un copolymère séquencé comprenant un bloc résistant à la gravure et un bloc hautement gravable sur le motif de photorésine et recuit jusqu'à ce qu'un auto-assemblage dirigé se produise ; et,
ivk) gravure du copolymère séquencé, éliminant ainsi le bloc hautement gravable des zones de surrevêtement de copolymère du substrat et formation simultanément d'un motif dans le substrat sélectivement dans ces zones.

16. Procédé de graphoépitaxie, auto-assemblage dirigé d'une couche de copolymère séquencé utilisé pour former une image, comprenant les étapes :
il) formation d'une couche neutre sur un substrat selon la revendication 13,
iil) application d'un revêtement de photorésine sur le revêtement de couche neutre,
formation d'un motif dans le revêtement de photorésine, formant ainsi des zones dans lesquelles le revêtement de couche neutre est découvert par le résist,
iiil) traitement du revêtement de couche neutre découvert pour l'éliminer, formant une zone d'épinglage,
ivl) élimination de la photorésine, découvrement du revêtement de couche neutre non affectée formant un motif chimioépitaxique contenant des zones neutres et d'épinglage,
vl) application d'un copolymère séquencé comprenant un bloc résistant à la gravure et un bloc hautement gravable sur le revêtement de couche neutre et recuit jusqu'à ce qu'un auto-assemblage dirigé se produise ; et,
vil) gravure du copolymère séquencé, éliminant ainsi le bloc hautement gravable des zones de revêtement de copolymère du substrat et formant simultanément un motif dans le substrat de manière sélective dans ces zones.

17. Utilisation du polymère selon l'une quelconque des revendications 1 à 10 ou de la composition selon la revendication 11 dans un procédé de préparation d'un revêtement greffé ou d'un revêtement auto-assemblé sur un substrat.
